(19) Europäisches Patentamt
European Patent Office
Office européen des brevets

(11) **EP 3 176 593 B1**

(12) **EUROPEAN PATENT SPECIFICATION**

(45) Date of publication and mention
of the grant of the patent:
**07.07.2021 Bulletin 2021/27**

(51) Int Cl.:
***G01R 19/00*** *(2006.01)*    ***G01R 15/20*** *(2006.01)*
***G01R 33/00*** *(2006.01)*    ***G01R 33/07*** *(2006.01)*

(21) Application number: **15844535.3**

(86) International application number:
**PCT/JP2015/004890**

(22) Date of filing: **25.09.2015**

(87) International publication number:
**WO 2016/047149 (31.03.2016 Gazette 2016/13)**

(54) **HALL ELECTROMOTIVE FORCE SIGNAL DETECTION CIRCUIT AND CURRENT SENSOR**

ELEKTROMOTORISCHE HALLEFFEKT-KRAFTSIGNALDETEKTIONSSCHALTUNG UND STROMSENSOR

CIRCUIT DE DÉTECTION DE SIGNAL DE FORCE ÉLECTROMOTRICE D'EFFET HALL ET CAPTEUR DE COURANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.09.2014 JP 2014196675**

(43) Date of publication of application:
**07.06.2017 Bulletin 2017/23**

(73) Proprietor: **Asahi Kasei Microdevices Corporation Tokyo 100-0006 (JP)**

(72) Inventors:
 • **NAKAMURA, Takenobu**
 **Tokyo 101-8101 (JP)**
 • **NISHIMURA, Yoshiyasu**
 **Tokyo 101-8101 (JP)**
 • **NOBIRA, Ryuji**
 **Tokyo 101-8101 (JP)**

(74) Representative: **Hoffmann Eitle Patent- und Rechtsanwälte PartmbB Arabellastraße 30 81925 München (DE)**

(56) References cited:
| | |
|---|---|
| JP-A- H10 285 001 | JP-A- 2006 126 012 |
| JP-A- 2006 126 012 | JP-A- 2008 513 762 |
| JP-A- 2013 178 229 | JP-A- 2014 127 813 |
| JP-A- 2014 167 422 | JP-A- 2014 517 919 |
| US-A- 5 844 427 | US-A1- 2012 286 776 |
| US-A1- 2013 193 962 | US-A1- 2014 103 921 |
| US-A1- 2014 210 458 | |

**Description**

Technical Field

The present invention relates to a Hall electromotive force signal detection circuit and a current sensor, and more particularly to a Hall electromotive force signal detection circuit and a current sensor, in which an offset cancellation means for a Hall element by using a spinning current technique is combined with a continuous-time signal processing circuit.

Background Art

A magnetic sensor using Hall elements is not only used as a sensor for detecting positional information of a magnet, such as a proximity sensor, a linear position sensor, or a rotation angle sensor, but also widely used in applications for a current sensor for contactlessly measuring the amount of current flowing through a current conductor by detecting a magnetic field induced by the current flowing therethrough. Particularly, a current sensor for use in detection of an inverter current in a motor is required to detect, with high precision, the current of an inverter performing switching at high frequency, for the purpose of efficient motor control.

In a case in which a magnetic sensor using Hall elements is used for measuring the current of an inverter, the magnetic sensor is required to have broadband properties associated with signal band, high-speed response properties associated with signal processing delay time, low noise properties associated with signal quality, and the like. Thus, in such a case, as a circuit system for processing Hall electromotive force signals generated in the Hall elements, a continuous-time signal processing circuit that performs signal processing in a continuous time is more advantageous than a discrete-time signal processing circuit that performs discrete-time processing, i.e., sampling. The continuous-time signal processing circuit causes no noise-folding phenomenon due to discrete-time processing (sampling). Thus, it is a circuit structure particularly suitable for use in environments with much high-frequency noise due to inverter switching.

A Hall element has an offset voltage (unbalanced voltage) that is a finite nonzero voltage output even in a state where magnetic field is zero, i.e., in a non-magnetic-field state. Then, magnetic sensors using Hall elements often use a Hall element drive technique known by a name, such as spinning current technique or connection commutation technique, in order to cancel out an offset voltage that Hall elements typically have. As will be described later, in this technique, an operation is performed that cyclically switches the position of a terminal pair for allowing a drive current to flow to a Hall element and the position of a terminal pair for detecting a Hall electromotive force signal according to a clock called chopper clock.

Additionally, for further downsizing magnetic sensors, silicon Hall elements that can be integrally formed with a CMOS circuit have been used in recent years.

For example, PTL 1 discloses a continuous-time Hall electromotive force signal detection circuit using such silicon Hall elements and the spinning current technique. In the literature, there is formed a signal amplification device that amplifies Hall electromotive force signals by transconductance amplifiers (hereinafter simply referred to Gm amplifiers) using transistor differential pairs. Gm amps have high input impedance, and thus are suitable for a signal amplification device for Hall elements that output a weak signal.

Citation List

Patent Literature

PTL 1: JP 2013-178229 A
US 2013/193962 A1 relates to a Hall electromotive force signal detection circuit combining offset cancellation means by a spinning current method of a Hall element with a continuous-time signal processing circuit. A first Hall element includes first to fourth terminals, and generates a Hall electromotive force signal voltage Vhall1. A third Hall element generates another Hall electromotive force signal voltage Vhall3. A first switching circuit is selecting a terminal position for applying a drive current from the four terminals of the first Hall element. A third switching circuit is selecting a terminal position for applying a drive current from the four terminals of the third Hall element, which is different from the terminal position selected by the first switching circuit. A chopper clock generation circuit supplies a chopper clock signal having two different phases to the switching circuit, and also supplies the chopper clock signal to the switching circuit.

US 5 844 427 A relates to a monolithic integrated sensor circuit and comprises a sensor system for generating an electronic sensor signal, a supply unit for the sensor system, an amplifying stage for amplifying the sensor signal, a plurality of inverting devices in the signal path of the amplifying stage which reverse the polarity of the sensor signal at equal time intervals, the time intervals and inversion of the sensor signal being controlled by a clock signal source, and an averaging combiner stage whose input is receiving an amplified sensor signal and whose output has a reference polarity which is controlled by means of the inverting devices in such a way as to be always the same regardless of the switching state in the signal path.

US 2014/103921 A1 relates to a circuit for biasing a plate-shaped sensor element made of doped semiconductor material and having a first/second excitation contact connected to a first/second excitation node, and a first/second sense contact connected to a first/second sense node. The plate-shaped sensor element is electrically isolated from a substrate or well by means of a first PN-junction.

JP 2006 126012 A relates to a hall element, a first current source, a coil, a second current source and a control circuit. The hall element detects magnetic field intensity and the first current source supplies the hall element with a drive current. The coil is arranged in the vicinity of the hall element. The second current source supplies the coil with an exiting current. The control circuit controls the current value of the drive current so that the difference between the output value of the hall element when the exiting current is supplied to the coil and the output value of the hall element when the exiting current is not supplied to the coil becomes constant.

US 2012/286776 A1 relates to a vertical Hall-effect device. The device includes at least two supply terminals arranged to supply electrical energy to the first Hall-effect region and at least one Hall signal terminal to provide a first Hall signal from the first Hall-effect region. The first Hall signal is indicative of a magnetic field which is parallel to the surface of the semiconductor substrate and which acts on the first Hall-effect region. One or more of the at least two supply terminals or one or more of the at least one Hall signal terminal comprises a force contact and a sense contact.

US 2014/210458 A1 relates to a method for reducing errors in sensor devices and systems. A sensor device comprises magnetic field sensors, such as an ordinary or a vertical Hall sensor device. In one example, at least two such sensor devices not electrically coupled with one another are sequentially operated in a spinning current-type mode such that an individual output signal from each of the at least two sensor devices is obtained.

JP 2014 167422 A relates to a Hall electromotive force signal detection circuit in which offset canceling means using a spinning current technique of a Hall element is combined with a continuous time signal processing circuit.

Summary of Invention

Technical Problem

In the continuous-time Hall electromotive force signal detection circuit using silicon Hall elements and a spinning current technique described in PTL 1, spike-like error signals may remain and vary. The present inventors found that, in order to actualize a higher-precision current sensor using continuous-time signal processing, it is necessary to suppress variations in the spike-like error signals mentioned above.

In other words, the inventors attempted to obtain higher-precision performance in a Hall electromotive force signal detection circuit and a current sensor including the circuit, and, as a result, found that the technique described in PTL 1 is unsatisfiable.

The present invention has been accomplished in view of such a problem, and it is an object of the invention to suppress variations in spike-like error signals that become obstacles to high-precision detection of Hall electromotive force signals in a Hall electromotive force signal detection circuit using a plurality of Hall elements driven by spinning current techniques and a plurality of transconductance amplifiers.

Solution to Problem

According to an aspect of the present invention, there is provided a Hall electromotive force signal detection circuit according to claim 1.

According to further aspect of the present invention, there is provided a corresponding current sensor.

Advantageous Effects of Invention

According to an aspect of the present invention, it is possible to suppress variations of the spike-like error signals that become obstacles to high-precision detection of a Hall electromotive force signal in the Hall electromotive force signal detection circuit using the plurality of Hall elements driven by the spinning current techniques and the plurality of transconductance amplifiers. As a result, a higher-precision current sensor can be actualized.

Brief Description of Drawings

FIG. 1 is a structural diagram depicting one example of a Hall electromotive force signal detection circuit;

FIGs. 2A to 2D are illustrative diagrams for illustrating a driving method for each of first and second Hall elements by a spinning current technique;

FIGs. 3A to 3D are illustrative diagrams for illustrating temporal changes of a differential signal A1 in the Hall electromotive force signal detection circuit depicted in FIG. 1;

FIGs. 4A to 4D are illustrative diagrams for illustrating temporal changes of a differential signal A2 in the Hall electromotive force signal detection circuit depicted in FIG. 1;

FIGs. 5A to 5E are illustrative diagrams for illustrating cancellation of spike signals different in polarity;

FIG. 6 is a block diagram depicting one example of the structure of a Hall electromotive force signal detection circuit according to a first embodiment;

FIG. 7 is an illustrative diagram for illustrating one example of the structure of a Hall signal feedback network of FIG. 6;

FIG. 8 is a block diagram depicting one example of the structure of a Hall electromotive force signal detection circuit according to a second embodiment;

FIG. 9 is an illustrative diagram for illustrating one example of the structure of a Hall signal feedback network of FIG. 8;

FIG. 10 is a modification of the Hall signal feedback network of FIG. 8;

FIG. 11 is a block diagram depicting one example of the structure of a Hall electromotive force signal detection circuit according to a third embodiment;

FIG. 12 is a block diagram depicting one example of the structure of a Hall electromotive force signal detection circuit according to a fourth embodiment;

FIG. 13 is a block diagram depicting one example of the structure of a Hall electromotive force signal detection circuit according to a fifth embodiment; and

FIG. 14 is a block diagram depicting one example of the structure of a feedback network controller of FIG. 13.

Description of Embodiments

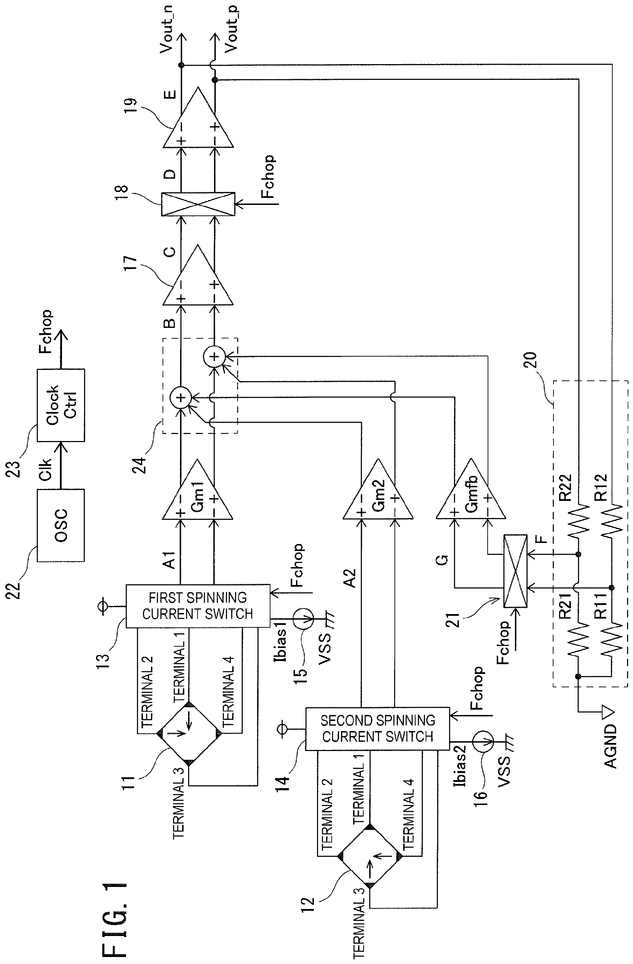

FIG. 1 is a schematic structure diagram depicting one example of a Hall electromotive force signal detection circuit.

The Hall electromotive force signal detection circuit depicted in FIG. 1 includes a first Hall element 11 and a second Hall element 12 each including four terminals (a terminal 1, a terminal 2, a terminal 3, and a terminal 4), a first spinning current switch 13, a second spinning current switch 14, a first Hall element drive current source 15, and a second Hall element drive current source 16. The Hall electromotive force signal detection circuit further includes a first transconductance amplifier Gm1, a second transconductance amplifier Gm2, a feedback transconductance amplifier Gmfb, an amplification stage 17, a chopper switch 18, an output stage 19, an output signal feedback network 20, a feedback chopper switch 21, an oscillator (OSC) 22, and a chopper clock generator (Clock Ctrl) 23. In addition, hereinafter, transconductance amplifier will be also referred to as Gm amplifier. For example, the first transconductance amplifier is referred to as first Gm amplifier, the second transconductance amplifier is referred to as second Gm amplifier, and the feedback transconductance amplifier is referred to as feedback Gm amplifier.

The current value of the first Hall element drive current source 15 is Ibias1, and the current value of the second Hall element drive current source is Ibias2. Additionally, the transconductance amplifier (Gm amplifier) is an amplifier having a function of converting a voltage signal to a current signal, and, for example, may be an amplifier using a transistor differential pair.

The oscillator 22 generates a clock signal Clk. The clock signal Clk is input to the chopper clock generator 23. The chopper clock generator 23 receives the clock signal Clk and generates a chopper clock Fchop.

The output signal Fchop of the chopper clock generator 23 is supplied to the first and the second spinning current switches 13 and 14, the chopper switch 18, and the feedback chopper switch 21, and each of these units performs switching of each switch according to phases φ1 and φ2 of the chopper clock Fchop. The four terminals 1 to 4 included in the first Hall element 11 are connected to the first spinning current switch 13, and the four terminals 1 to 4 included in the second Hall element 12 are connected to the second spinning current switch 14. In addition, the first Hall element drive current source 15 is connected to the first spinning current switch 13, and the second Hall element drive current source 16 is connected to the second spinning current switch 14.

With such a structure, the first and second Hall elements 11 and 12 driven by spinning current techniques that will be described later, by the first and second spinning current switches 13 and 14, respectively. The first spinning current switch 13 includes a plurality of switches, and supplies a differential signal A1 (indicated by A1 in FIG. 1) including a Hall electromotive force signal obtained from the first Hall element 11 by driving the first Hall element 11 by a spinning current technique described later to the first Gm amplifier Gm1. Similarly, the second spinning current switch 14 includes a plurality of switches, and supplies a differential signal A2 (indicated by A2 in FIG. 1) including a Hall electromotive force signal obtained from the second Hall element 12 by driving the second Hall element 12 by a spinning current technique described later to the second Gm amplifier Gm2. In order to facilitate driving by the spinning current technique, preferably, positions of the terminals of the first Hall element correspond to positions of the terminals of the second Hall element, as in FIG. 1.

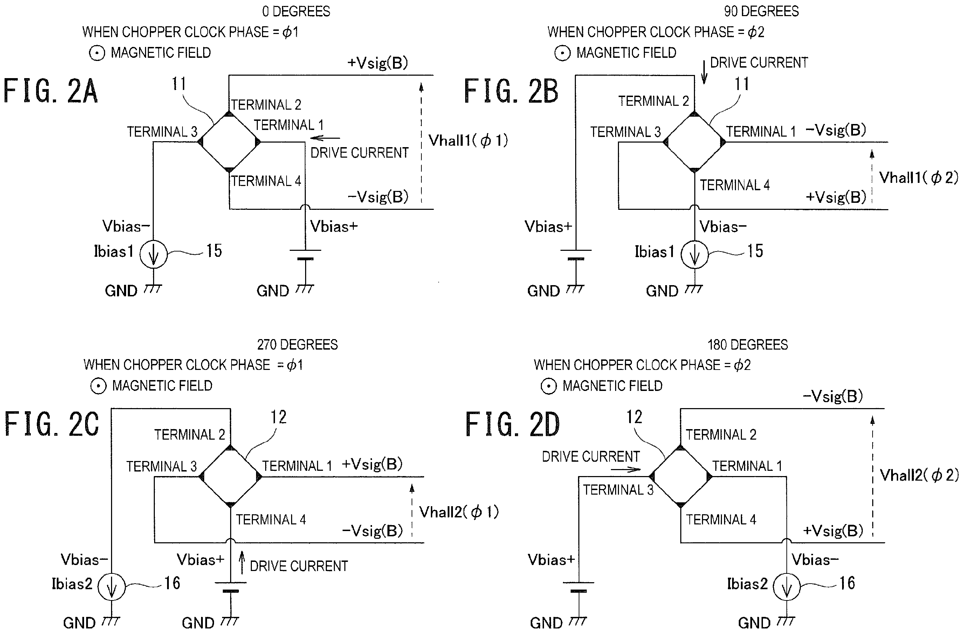

FIGs. 2A to 2D are illustrative diagrams of a case in which the first Hall element 11 and the second Hall element 12 of FIG. 1 are driven by the spinning current technique.

In the spinning current technique, the direction of current flown from the respective terminals 1 to 4 of each of the Hall elements represents the driving state of the Hall element. For example, as already mentioned, each of the Hall elements 11 and 12 of FIG. 1 includes the terminal 1, the terminal 2, the terminal 3, and the terminal 4, respectively. When the case of a current flow from the terminal 1 to the terminal 3 is defined as 0-degree direction, the case of a current flow from the terminal 2 to the terminal 4 is referred to as 90-degree direction, the case of a current flow from the terminal 3 to the terminal 1 is referred to as 180-degree direction, and the case of a current flow from the terminal 4 to the terminal 2 is referred to as 270-degree direction. Hereinafter, a description will be given according to the definitions.

FIGs. 2A and 2B are diagrams illustrating a spinning current technique for the first Hall element 11. In the first Hall element 11, each time the phase of the chopper clock Fchop is switched between two values $\varphi1$ and $\varphi2$, the direction of a drive current that biases the Hall element 11 is switched between the 0-degree direction and the 90-degree direction, respectively. This is referred to as first spinning current technique.

Then, when the phase of the chopper clock Fchop is $\varphi1$, the potential of the terminal 2 with respect to the terminal 4 is measured as a voltage signal Vhall1 ($\varphi1$), and when the phase thereof is $\varphi2$, the potential of the terminal 1 with respect to the terminal 3 is measured as a voltage signal Vhall1 ($\varphi2$) . In this case, the Vhall1 ($\varphi1$) and the Vhall1 ($\varphi2$) are represented as a sum of a Hall electromotive force signal component Vsig(B) corresponding to a magnetic field B that is a detection target of a magnetic sensor using the Hall element 11 and an offset voltage Vos (Hall) of the Hall element 11, as indicated by the following formula (1):

$$\mathrm{Vhall1}(\varphi1) = +2\mathrm{Vsig}(B) + \mathrm{Vos}(\mathrm{Hall})$$

$$(\text{when the phase of the chopper clock Fchop is } \varphi1)$$

$$\mathrm{Vhall1}(\varphi2) = -2\mathrm{Vsig}(B) + \mathrm{Vos}(\mathrm{Hall})$$

$$(\text{when the phase of the chopper clock Fchop is } \varphi2)$$

$$\ldots\ldots\ldots\ldots (1)$$

The voltage signal Vhallls (Vhall1($\varphi1$) and Vhall1 (($\varphi2$)) become a differential signal A1 that is supplied from the first spinning current switch 13 to the first Gm amplifier Gm1.

FIGs. 2C and 2D are diagrams for illustrating a spinning current technique for the second Hall element 12. In the second Hall element 12, each time the phase of the chopper clock Fchop is switched between two values $\varphi1$ and $\varphi2$, the direction of a drive current that biases the Hall element 12 is switched between the 270-degree direction and the 180-degree direction, respectively. This is referred to as second spinning current technique. Then, when the phase of the chopper clock Fchop is $\varphi1$, the potential of the terminal 1 with respect to the terminal 3 is measured as a voltage signal Vhall2($\varphi1$), and when the phase thereof is $\varphi2$, the potential of the terminal 2 with respect to the terminal 4 is measured as a voltage signal Vhall2 ($\varphi2$). In this case, the Vhall2 ($\varphi1$) and the Vhall2 ($\varphi2$) are represented as a sum of a Hall electromotive force signal component Vsig(B) corresponding to a magnetic field B that is a detection target of a magnetic sensor using the Hall element 12 and an offset voltage Vos(Hall) of the Hall element 12, as indicated by the following formula (2):

$$\mathrm{Vhall2}(\varphi1) = +2\mathrm{Vsig}(B) + \mathrm{Vos}(\mathrm{Hall})$$

$$(\text{when the phase of the chopper clock Fchop is } \varphi1)$$

$$\mathrm{Vhall2}(\varphi2) = -2\mathrm{Vsig}(B) + \mathrm{Vos}(\mathrm{Hall})$$

$$(\text{when the phase of the chopper clock Fchop is } \varphi2)$$

$$\ldots\ldots\ldots\ldots (2)$$

The voltage signals Vhall2 (Vhall2 ($\varphi$1) and Vhall2 ($\varphi$2)) become a differential signal (A2) that is supplied from the second spinning current switch 14 to the second Gm amplifier Gm2.

Then, the first Gm amplifier Gm1 converts the differential signal A1 from voltage to current by gm1 that is a voltage-to-current conversion coefficient, i.e., a transconductance value (hereinafter represented as gm value), the second Gm amplifier Gm2 converts the differential signal A2 from voltage to current by gm2, and the feedback Gm amplifier Gmfb converts a differential signal G that will be described later, from voltage to current by gmfb.

Output ends of the first, the second, and the feedback Gm amplifiers Gm1, Gm2, and Gmfb, respectively, are connected to an addition node 24, and current signals converted by the respective Gm amplifiers are all added together to create a differential signal B (indicated by B in FIG. 1).

Additionally, the amplification stage 17 is connected to the addition node 24 to receive the differential signal B, and outputs a differential signal C (indicated by C in FIG. 1) created by amplifying the differential signal B. The amplification stage 17 is an amplifier that amplifies an input signal and outputs this amplified signal, which is, for example, a transimpedance amplifier and a current-to-voltage conversion amplifier.

Then, the chopper switch 18 is connected to an output end of the amplification stage 17 to receive the differential signal C. The chopper switch 18 demodulates the differential signal C by the chopper clock Fchop and outputs a differential signal D (indicated by D in FIG. 1). Then, the output stage 19 is connected to an output end of the chopper switch 18 to receive the differential signal D and outputs a differential signal E (indicated by E in FIG. 1) created by amplifying the differential signal D. The differential signal E becomes an output Vout of the Hall electromotive force signal detection circuit. Then, the output signal feedback network 20 is connected to receive the differential signal E and outputs a differential signal F (indicated by F in FIG. 1). Furthermore, the feedback chopper switch 21 is connected to the output signal feedback network 20 to receive the differential signal F and outputs a differential signal G (indicated by G in FIG. 1) modulated by the chopper clock Fchop. The differential signal G is supplied to the feedback Gm amplifier Gmfb.

The output signal feedback network 20 of FIG. 1 includes a resistor R11, a resistor R12, a resistor R21, and a resistor R22. One ends of the resistors R11 and R21 are connected to an analog ground (hereinafter also referred to as AGND), and the other ends thereof, respectively, are connected to one ends of the resistors R12 and R22.

When the output signal of the output stage 19, i.e., a positive phase component and a negative phase component of the differential signal E are represented by Vout_p and Vout_n, the differential signal E, i.e., the output Vout of the Hall electromotive force signal detection circuit is represented by a difference therebetween. In other words, it is represented by Vout = Vout_p - Vout_n. Additionally, the other ends of the resistors R12 and R22, respectively, are connected to output ends of the output stage 19.

When resistance values of the resistors R11, R12, R21, and R22 are defined as R11 = R21 and R12 = R22, the output Vout of the Hall electromotive force signal detection circuit can be represented by the following formula (3) using the gm values of the first, the second, and the feedback Gm amplifiers Gm1, Gm2, and Gmfb, i.e., gm1, gm2, and gmfb:

$$\texttt{Vout = (1 + R12/R11)} \times \{\texttt{(gm1/gmfb)} \times \texttt{Vhall1}$$
$$+ \texttt{(gm2/gmfb)} \times \texttt{Vhall2}\} \dots\dots\dots\dots (3)$$

Here, when gm1 as the gm value of the first Gm amplifier Gm1 and gm2 as the gm value of the second Gm amplifier Gm2 are set to be gm1 = gm2 = gm_hall, formula (3) is represented by the following formula (4):

$$\texttt{Vout = (1 + R12/R11)}$$
$$\times \{\texttt{(gm\_hall/gmfb)} \times \texttt{(Vhall1 + Vhall2)}\} \dots\dots\dots\dots (4)$$

Meanwhile, when detecting a Hall electromotive force signal in the continuous-time signal processing system, it is important to suppress an error signal called spike that is generated upon switching of a switch. The spike becomes a cause of a distorted sine wave or a residual offset, and therefore when a current sensor is used for controlling a motor, the spike causes a torque ripple in the motor and becomes an obstacle to smooth motor control. Additionally, the spike is classified into two kinds depending on the cause of generation. Here, one of the two kinds of spikes is referred to as first spike, and the other one thereof is referred to as second spike. Then, in the output of the Hall electromotive force signal detection circuit, suppression of variations in the first and the second spikes allows a sine wave to be precisely smoothed, and also leads to suppression of variations in residual offset. Thus, the suppression of variations therein is important in a current sensor using continuous-time signal processing.

However, the present inventors found a new problem as below in suppressing the first and the second spikes in the Hall electromotive force signal detection circuit depicted in FIG. 1.

First will be a description of the first spike.

The cause of generation of the first spike is a temporal transition in shifting from bias voltages "Vbias+ and Vbias-" determined by flow of a drive current to the Hall elements to voltages of the Hall electromotive force signals when driven by the spinning current techniques. In addition, in FIGs. 2A to 2D, high-voltage side is set to be "Vbias+", and current-source side is set to be "Vbias-".

The degree of generation of the first spike varies depending on the order of selection of and switching between terminals to which a drive current for the Hall elements is applied and also the sequence thereof in the spinning current techniques.

The Hall electromotive force signal detection circuit depicted in FIG. 1 uses the fact that the polarity of a spike signal generated by driving the first Hall element 11 by the first spinning current technique and the polarity of a spike signal generated by driving the second Hall element 12 by the second spinning current technique are different from each other between when the phase of the chopper clock Fchop is $\varphi1$ and when it is $\varphi2$. Specifically, the Hall electromotive force signal detection circuit depicted in FIG. 1 aims for cancellation and nullification of spike signal components included in both differential signals A1 and A2 by allowing the addition node 24 to add the mutual outputs of the first Gm amplifier Gm1 and the second Gm amplifier Gm2 to add the differential signal A1 and the differential signal A2 including the spike signal components.

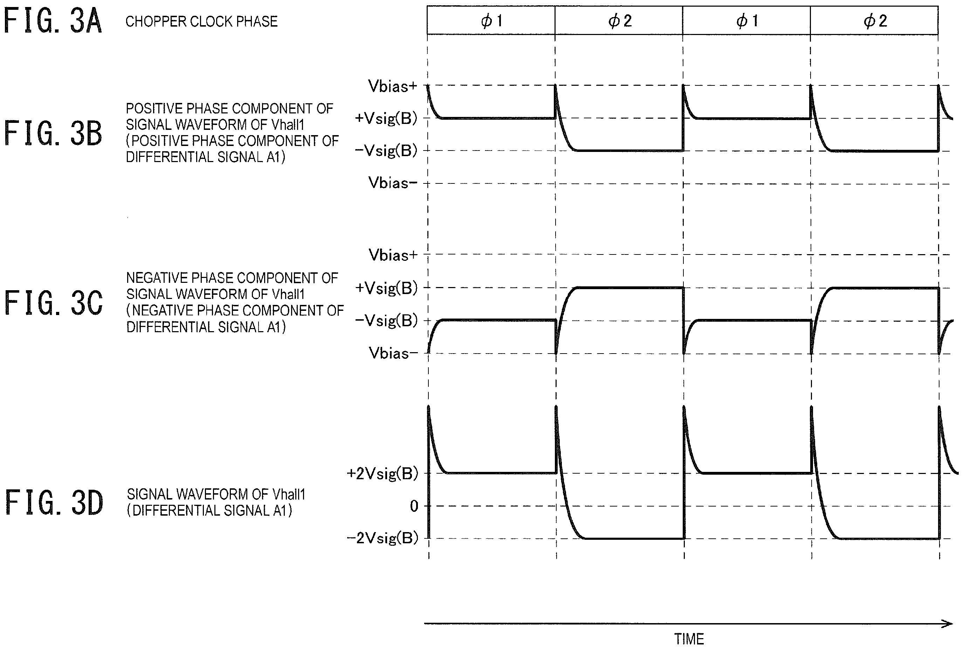

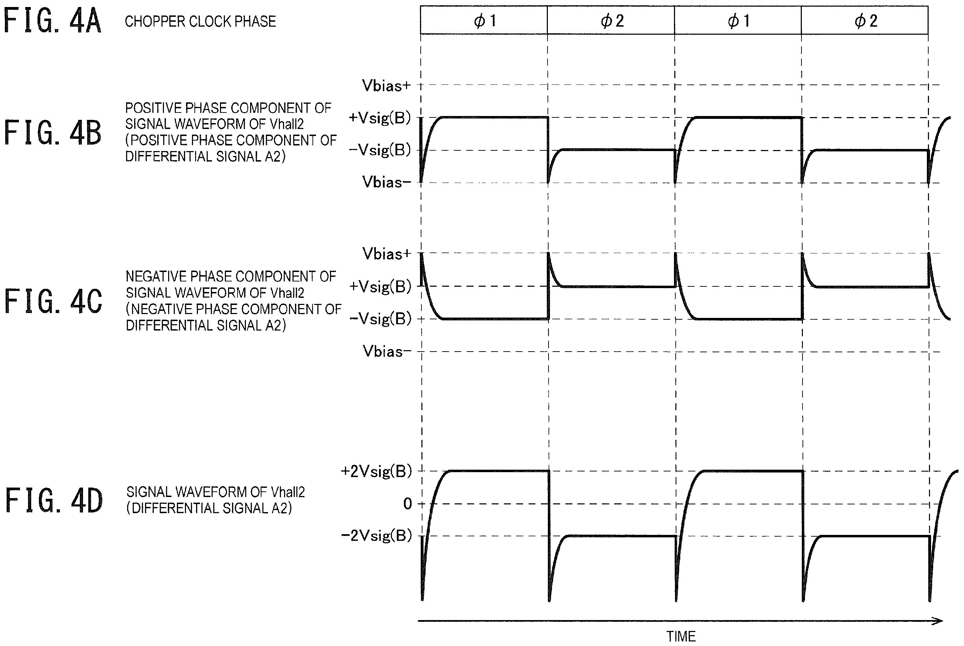

FIGs. 3A to 3D and FIGs. 4A to 4D are diagrams for illustrating temporal changes of positive phase components and negative phase components of the differential signal A1 and the differential signal A2 and of the differential signals in the Hall electromotive force signal detection circuit depicted in FIG. 1.

FIG. 3A depicts the phases of the chopper clock Fchop, FIG. 3B depicts a positive phase component of a signal waveform of the voltage signal Vhall1 of the Hall element 11, i.e. , the positive phase component of the differential signal A1, FIG. 3C depicts a negative phase component of a signal waveform of the voltage signal Vhall1, i.e., the negative phase component of the differential signal A1, and FIG. 3D depicts a signal waveform of the voltage signal Vhall1, i.e. , the differential signal A1.

Similarly, FIG. 4A depicts the phases of the chopper clock Fchop, FIG. 4B depicts a positive phase component of a signal waveform of the voltage signal Vhall2 of the Hall element 12, i.e., the positive phase component of the differential signal A2, FIG. 4C depicts a negative phase component of a signal waveform of the voltage signal Vhall2, i.e. , the negative phase component of the differential signal A2, and FIG. 4D depicts a signal waveform of the voltage signal Vhall2, i.e., the differential signal A2.

In FIGs. 3A to 3D, in the phase $\varphi1$ of the chopper clock Fchop, the positive phase component of the differential signal A1 transitions from the bias voltage "Vbias+" to the Hall electromotive force signal voltage "+Vsig(B)", and, in the phase $\varphi2$ of the chopper clock Fchop, transitions from the bias voltage "Vbias+" to the Hall electromotive force signal voltage "-Vsig (B) " . In other words, the peak polarity of the spike signal component of the positive phase component of the differential signal A1 is always indicated by plus sign. In addition, the offset component is ignored to simplify the description.

On the other hand, the negative phase component of the differential signal A1 transitions from the bias voltage "Vbias-" to the Hall electromotive force signal voltage "-Vsig(B)" in the phase $\varphi1$ of the chopper clock Fchop, and transitions from the bias voltage "Vbias-" to the Hall electromotive force signal voltage "+Vsig(B)" in the phase $\varphi2$ of the chopper clock Fchop. In other words, the peak polarity of the spike signal component of the negative phase component of the differential signal A1 is always indicated by minus sign. Accordingly, since the differential signal A1 is the difference between the positive phase component and the negative phase component, it can be seen that the spike signal component thereof always has peak polarity indicated by plus sign.

In FIGs. 4A to 4D, in the phase $\varphi1$ of the chopper clock Fchop, the positive phase component of the differential signal A2 transitions from the bias voltage "Vbias-" to the Hall electromotive force signal voltage "+Vsig (B) ", and, in the phase $\varphi2$ of the chopper clock Fchop, transitions from the bias voltage "Vbias-" to the Hall electromotive force signal voltage "-Vsig (B)". In other words, the peak polarity of the spike signal component of the positive phase component of the differential signal A2 is always indicated by minus sign.

On the other hand, the negative phase component of the differential signal A2 transitions from the bias voltage "Vbias+" to the Hall electromotive force signal voltage "-Vsig(B)" in the phase $\varphi1$ of the chopper clock Fchop, and, in the phase $\varphi2$ of the chopper clock Fchop, transitions from the bias voltage "Vbias+" to the Hall electromotive force signal voltage "+Vsig (B)". In other words, the peak polarity of the spike signal component of the negative phase component of the differential signal A2 is always indicated by plus sign. Accordingly, since the differential signal A2 is the difference between the positive phase component and the negative phase component, it can be seen that the spike signal component thereof always has peak polarity indicated by minus sign.

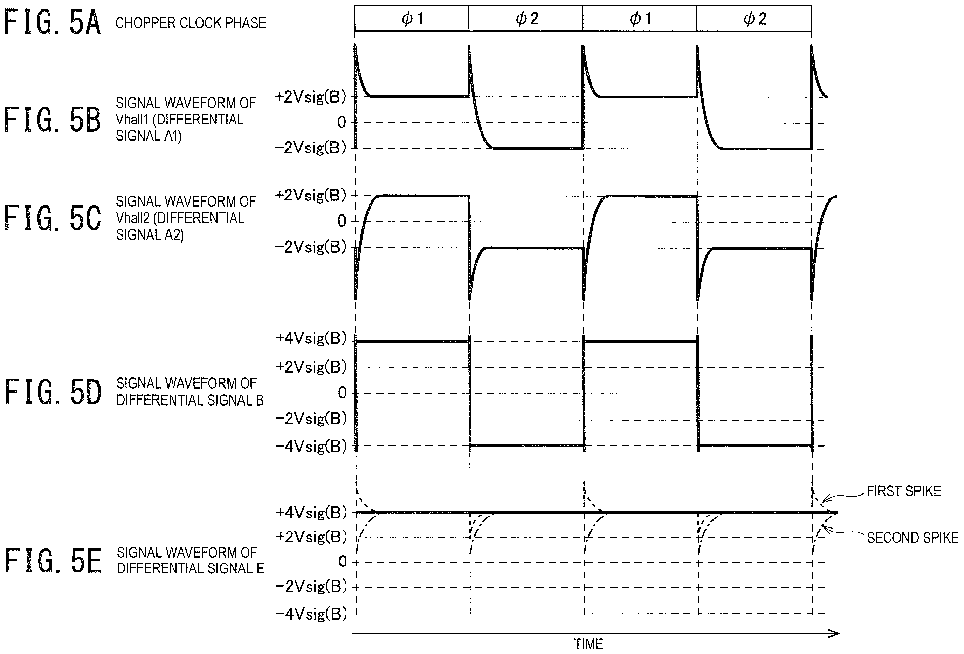

FIGs. 5A to 5E are diagrams for illustrating cancellation of the spike signals different in polarity.

FIG. 5A depicts the phases $\varphi1$ and $\varphi2$ of the chopper clock Fchop, FIG. 5B depicts a signal waveform of the voltage signal Vhall1 of the Hall element 11, i.e., the differential signal A1, FIG. 5C depicts a signal waveform of the voltage signal Vhall2 of the Hall element 12, i.e., the differential signal A2, FIG. 5D depicts a signal waveform of the differential signal B, and FIG. 5E depicts a signal waveform of the differential signal E.

As depicted in FIGs. 5A to 5E, in the phase φ1 of the chopper clock Fchop, both of the differential signal A1 and the differential signal A2 become "2Vsig(B)", and, in the φ2, become "-2Vsig(B)", in which they vibrate. However, as described above, the spike signal of the differential signal A1 transitions from the plus sign peaks when a phase is either one of phases φ1 and φ2 of the chopper clock Fchop, whereas the spike signal of the differential signal A2 transitions from the minus sign peaks when a phase is either one of phases φ1 and φ2 thereof.

Accordingly, the differential signal B that is the signal created by current conversion of the differential signal A1 and the differential signal A2 by the first and the second Gm amplifiers Gm1 and Gm2, respectively, and addition thereof vibrates as "+4Vsig (B)" and "-4Vsig (B) ", respectively, when the phase of the chopper clock Fchop is φ1 and when it is φ2, but influence of the spike signals is cancelled out and there is no temporal transition, as depicted in FIG. 5D.

Then, the differential signal B in which the spike signals have been cancelled out is amplified by the amplification stage 17 to become the differential signal C. The differential signal C is then demodulated by the chopper switch 18 and further amplified by the output stage 19 to be output as the differential signal E. FIG. 5E depicts temporal changes of the differential signal E by a solid line. As is obvious, even in the differential signal E, there is no influence of the spike signals.

In order to cancel out the spike signals, it is necessary that the gm1 and the gm2 as the gm values of the first Gm amplifier Gm1 and the second Gm amplifier Gm2 are always equal. However, in the Hall elements formed on a silicon substrate, the thickness of a depletion layer formed by PN junction changes depending on temperature and a Hall common voltage influenced by the depletion layer varies, whereby DC potential of the gates of a transistor differential pair used for the input of each Gm amplifier also varies. In short, the operating point of the transistor differential pair varies, and the gm values vary.

Here, the Hall common voltage is a common voltage of an output voltage from which a Hall electromotive force signal is extracted. Usually, the output signal of a Hall element is treated as a differential signal, and therefore an intermediate potential of the positive phase component and the negative phase component of the differential signal is a common voltage. In other words, the intermediate potential of the differential output terminal pair of a Hall element (for example, the pair of the terminal 1 and the terminal 3, and the pair of the terminal 2 and the terminal 4 of the first Hall element) is a common voltage. The Hall common voltage may be called the common voltage of the Hall element, or may be called the common voltage of the output signal of the Hall element. Additionally, since the Hall common voltage is a common voltage that becomes a reference for the positive phase component and the negative phase component of the Hall electromotive force signal included in the differential output signal of the Hall element, it may also be called the common voltage of the Hall electromotive force signal.

Additionally, the state of the formed depletion layer is different between the respective Hall elements depending on the density distribution of an impurity concentration due to process gradients in manufacturing a semiconductor, and therefore the variation of the depletion layer is also different between the respective Hall elements. Accordingly, since the Hall common voltage will become different between the respective Hall elements, the gm 1 as the gm value of the first Gm amplifier Gm1 will also become different from the gm2 as the gm value of the second Gm amplifier Gm2. Due to this, in attempting to obtain higher-precision performance in a Hall electromotive force signal detection circuit and a current sensor using the Hall electromotive force signal detection circuit, the inventors found that cancellation of the spike signals described above become insufficient due to the variation of the gm1 and the gm2, and spike signals remain in the differential signal E as the output of the Hall electromotive force signal detection circuit of FIG. 1, as indicated by superimposing with broken lines on the differential signal E of FIG. 5E. Such residual spike signals become obstacles to actualization of a high-precision current sensor.

Next, a description will be given of the second spike signal.

The second spike signal is dependent on frequency characteristics of a main signal path, i.e., a signal path from the differential signals A1 and A2 to the differential signals B, C, D, and E and frequency characteristics of a signal path of the output signal feedback network 20, i.e., a signal path from the differential signal E to the differential signals F, G, B, C, D, and E. For example, the second spike signal is generated by a difference between signal delay times of the two signal paths. The second spike signal is indicated, for example, by superimposing with dot-and-dash lines on the differential signal E of FIG. 5E.

Then, gains of the frequency characteristics of the two signal paths are influenced by the gm values of the Gm amplifiers, and it is therefore important to stabilize the gm values in order to obtain stable frequency characteristics.

However, as described above, the gm value gm1 of the first Gm amplifier Gm1 and the gm value gm2 of the second Gm amplifier Gm2 vary depending on temperature. Due to that, a ratio between the gm values gm1 and gmfb or a ratio between the gm2 and the gmfb vary, which also becomes a factor that causes spike signal variations.

In other words, the instability and variation of the spike signal in the differential signal E as the output obstruct actualization of a higher-precision current sensor.

(First Embodiment)

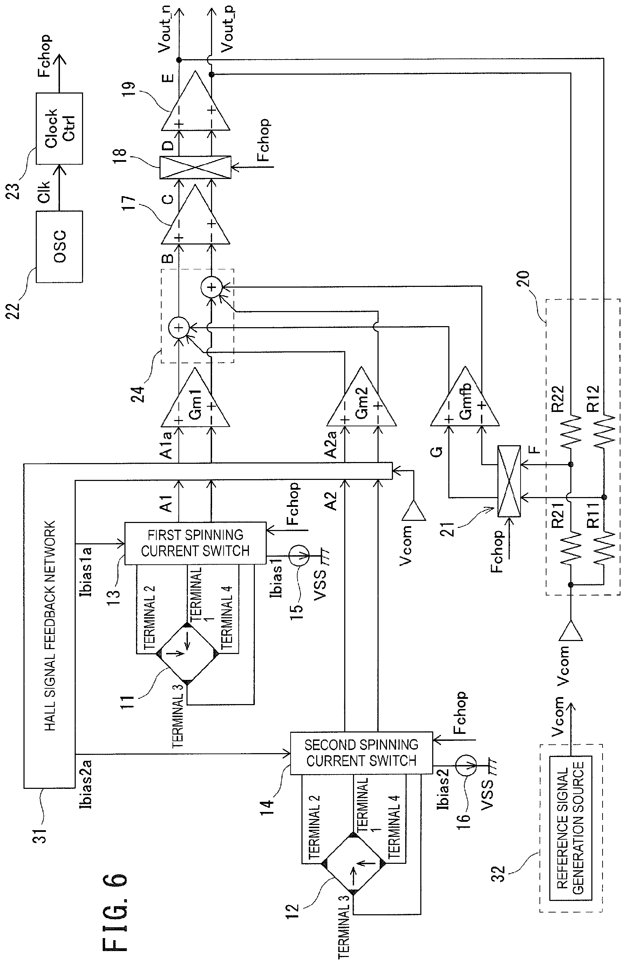

FIG. 6 is a block diagram depicting one example of the structure of a Hall electromotive force signal detection circuit according to a first embodiment of the present invention. In addition, the same parts as those in the Hall electromotive force signal detection circuit depicted in FIG. 1 are denoted by the same reference signs, and descriptions thereof will be omitted.

The Hall electromotive force signal detection circuit according to the first embodiment depicted in FIG. 6 includes the first Hall element 11 and the second Hall element 12 each including the four terminals (terminal 1, terminal 2, terminal 3, and terminal 4), the first spinning current switch 13, the second spinning current switch 14, the first Hall element drive current source 15, the second Hall element drive current source 16, and a Hall signal feedback network 31. Furthermore, the Hall electromotive force signal detection circuit includes the first Gm amplifier Gm1, the second Gm amplifier Gm2, the feedback Gm amplifier Gmfb, the amplification stage 17, the chopper switch 18, the output stage 19, the output signal feedback network 20, the feedback chopper switch 21, the oscillator (OSC) 22, the chopper clock generator 23, and a feedback network controller 32.

The feedback network controller 32 is formed by including, for example, a reference signal generation source, and is formed by using, for example, a constant voltage circuit (a regulator circuit) stable against temperature. The feedback network controller 32 generates the reference signal Vcom including a voltage signal.

In addition, the current value of the first Hall element drive current source 15 is Ibias1, and the current value of the second Hall element drive current source 16 is Ibias2.

The Hall electromotive force signal detection circuit depicted in FIG. 6 is different from the Hall electromotive force signal detection circuit depicted in FIG. 1 in that the former further includes the Hall signal feedback network 31 and the feedback network controller 32.

The oscillator 22 generates the clock signal Clk. The clock signal Clk is output to the chopper clock generator 23 . The chopper clock generator 23 receives the clock signal Clk and generates the chopper clock Fchop.

The output signal Fchop of the chopper clock generator 23 is supplied to the first and the second spinning current switches 13 and 14, the chopper switch 18, and the feedback chopper switch 21, and each of these units performs switching of each switch according to the phases φ1 and φ2 of the chopper clock Fchop.

The four terminals 1 to 4 included in the first Hall element 11 are connected to the first spinning current switch 13, and the four terminals 1 to 4 included in the second Hall element 12 are connected to the second spinning current switch 14. Additionally, the first Hall element drive current source 15 and the second Hall element drive current source 16 are connected to the first and the second spinning current switches 13 and 14, respectively. In addition, a first Hall element drive correction current Ibias1a is supplied from the Hall signal feedback network 31 to the first spinning current switch 13, and a second Hall element drive correction current Ibias2a is supplied from the Hall signal feedback network 31 to the second spinning current switch 14.

With the structure thus formed, the first and the second Hall elements 11 and 12 are driven by the first and the second spinning current switches 13 and 14, respectively. Additionally, the first Hall element 11 is driven by the first spinning current technique described above by the first spinning current switch 13. In other words, the direction of a drive current that biases the Hall element 11 is switched between the 0-degree direction and the 90-degree direction. The second Hall element 12 is driven by the second spinning current technique described above by the second spinning current switch 14. In other words, the direction of a drive current that biases the Hall element 12 is switched between the 270-degree direction and the 180-degree direction.

In addition, as depicted in FIGs. 2A to 2D, when the spinning current switch performs driving to the O-degree direction, the first or second Hall element drive correction current Ibias1a or Ibias2a is input to the terminal 1 of the Hall element (input along a drive current direction of FIG. 2A). Similarly, in the case of driving to the 90-degree direction, the correction current is input to the terminal 2 (input along a drive current direction of FIG. 2B); in the case of driving to the 270-degree direction, the correction current is input to the terminal 4 (input along a drive current direction of FIG. 2C); and, in the case of driving to the 180-degree direction, the correction current is input to the terminal 3 (input along a drive current direction of FIG. 2D) .

Then, the first spinning current switch 13 supplies the differential signal A1 (indicated by A1 in FIG. 6) including a Hall electromotive force signal from the first Hall element 11 to the Hall signal feedback network 31. The second spinning current switch 14 supplies the differential signal A2 (indicated by A2 in FIG. 6) including a Hall electromotive force signal from the second Hall element 12 to the Hall signal feedback network 31.

The Hall signal feedback network 31 receives the differential signal A1, the differential signal A2, and the reference signal Vcom from the feedback network controller 32, supplies the first Hall element drive correction current Ibias1a to the first spinning current switch 13, and supplies the second Hall element drive correction current Ibias2a to the second spinning current switch 14. Additionally, the Hall signal feedback network 31 supplies the differential signal A1 directly as a differential signal A1a to the first Gm amplifier Gm1, and supplies the differential signal A2 directly as a differential signal A2a to the second Gm amplifier Gm2.

Here, in the description of the first embodiment, the reference signal Vcom output by the feedback network controller 32 is, for example, VDD/2 where VDD represents a power supply voltage that is supplied to the Hall electromotive force signal detection circuit.

Operations by the feedback Gm amplifier Gmfb, the amplification stage 17, the chopper switch 18, the output stage 19, and the feedback chopper switch 21 are the same as those in the Hall electromotive force signal detection circuit depicted in FIG. 1.

The output signal feedback network 20 is configured to receive the reference signal Vcom from the feedback network controller 32 and the differential signal E, and supplies a differential signal F to the feedback chopper switch 21.

In FIG. 6, the output signal feedback network 20 includes the resistors R11, R12, R21, and R22. The reference signal Vcom is input to one ends of the resistors R11 and R21. The other ends of the resistors R11 and R21 are connected to the resistors R12 and R22, respectively. When the positive phase component of an output signal of the output stage 19, i.e., the differential signal E is Vout_p and the negative phase component thereof is Vout_n, the differential signal E is represented by a difference therebetween (i.e. , Vout = Vout_p - Vout_n) . The other ends of the resistors R12 and R22 are respectively connected to output terminals of the output stage 19, and the Vout_n and the Vout_p, respectively, are input thsereto.

When the positive phase component of the differential signal F is Vf_p and the negative phase component thereof is Vf_n, and the signal level of the reference signal is Vcom, the output signal feedback network 20 outputs the differential signal F represented by the following formula (5) :

$$Vf\_p = (Vout\_n - Vcom) \times R21/(R21 + R22) + Vcom$$

$$Vf\_n = (Vout\_p - Vcom) \times R11/(R11 + R12) + Vcom$$

$$\cdots\cdots\cdots\cdots\cdots\cdots \quad (5)$$

Here, when R11 = R21 and R12 = R22, the differential signal F is a signal centered on the reference signal Vcom. The differential signal G is a signal in which the positive phase component and the negative phase component of the differential signal F are switched between the phases of the chopper clock by the feedback chopper switch 21, and therefore, similarly, is a signal centered on the reference signal Vcom. In other words, the operating point and gm value gmfb of the feedback Gm amplifier Gmfb are determined by the reference signal Vcom.

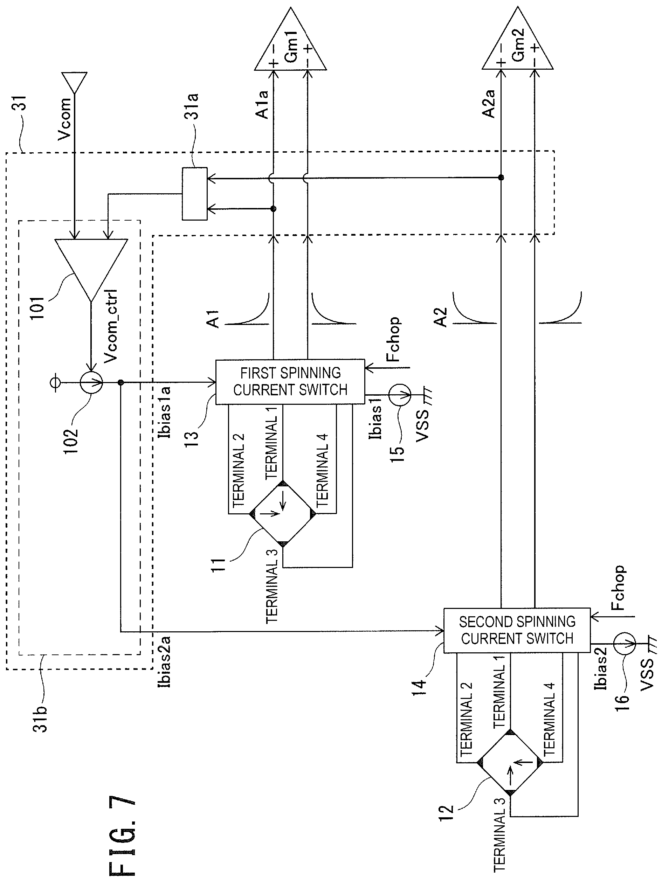

FIG. 7 is a diagram for illustrating one example of the structure of the Hall signal feedback network 31 in the first embodiment depicted in FIG. 6.

As depicted in FIG. 7, the Hall signal feedback network 31 includes a plural Hall common voltage calculation unit 31a and a plural Hall common voltage control unit 31b, and the plural Hall common voltage control unit 31b includes a comparison unit 101 and a variable current source 102.

The plural Hall common voltage calculation unit 31a receives the positive phase component of the differential signal A1 and the positive phase component of the differential signal A2, calculates an average common voltage Vhcom_pl of the plurality of Hall elements, i. e. , the first and the second Hall elements 11 and 12, and supplies it to the comparison unit 101 of the plural Hall common voltage control unit 31b.

As for the plural Hall common voltage calculation unit 31a, a structure may be used in which voltage-to-current conversion and addition are performed by transistors receiving the positive phase component of the differential signal A1 and the positive phase component of the differential signal A2, respectively. The comparison unit 101 may be a comparator. In addition, the plural Hall common voltage calculation unit 31a and the comparison unit 101 may be formed as a single comparator using a plurality of transistors for input. Additionally, the variable current source 102 may be formed by a MOS transistor.

Here, the positive phase component of the differential signal A1 and the positive phase component of the differential signal A2 are defined as Va1_p and Va2_p, respectively; the Hall common voltages of the first and the second Hall elements 11 and 12 are defined as Vhcom1 and Vhcom2, respectively; and a spike component superimposed on each component is defined as Vspike. When considering the polarity of the spike component Vspike, the positive phase component of the differential signal A1 and the positive phase component of the differential signal A2 output from the first and the second spinning current switches 13 and 14 can be represented by the following formula (6), from FIGs. 3A to 3D and FIGs. 4A to 4D described above:

$$Va1\_p = Vhcom1 + Vspike + Vsig(B)$$

$$Va2\_p = Vhcom2 - Vspike + Vsig(B) \quad \dots\dots\dots\dots \quad (6)$$

Here, the average common voltage Vhcom_pl can be represented by the following formula (7):

$$Vhcom\_pl = (Va1\_p + Va2\_p)/2$$

$$= (Vhcom1 + Vhcom2)/2 + Vsig(B)$$

$$\approx (Vhcom1 + Vhcom2)/2$$

$$(\because Vsig(B) \ll (Vhcom1 + Vhcom2)/2) \quad \dots\dots\dots\dots \quad (7)$$

Specifically, the average common voltage Vhcom_pl is an average value of the two Hall common voltages Vhcom1 and Vhcom2 of the first Hall element 11 and the second Hall element 12. Here, as can be seen from formula (7), the influence of the spike component has been cancelled out. In short, the influence of spike components generated in the output signals of the first and the second spinning current switches 13 and 14 is eliminated by the plural Hall common voltage calculation unit 31a.

In addition, the last term Vsig (B) in formula (7) is about 30 mV when the first and the second Hall elements 11 and 12 are silicon Hall elements and even if an input magnetic field is large. Accordingly, for example, when power supply voltage is 3 V, the magnitude of the Vsig(B) is extremely small as compared to the Hall common voltages Vhcom1 and Vhcom2 of the first and the second Hall elements 11 and 12 designed to be in a range from 1 to 2 V.

Specifically, the plural Hall common voltage calculation unit 31a detects the average common voltage Vhcom_pl by correction (arithmetic averaging) between the positive phase components of the respective differential outputs of the first spinning current switch 13 and the second spinning current switch 14, i.e., the mutually same phase components thereof.

The comparison unit 101 receives the reference signal Vcom and the average common voltage Vhcom_pl of the first and the second Hall elements 11 and 12 and compares both thereof. Then, the comparison unit 101 supplies a plural Hall common voltage control signal Vcom_ctrl for controlling so that the average common voltage Vhcom_pl of the first and the second Hall elements 11 and 12 is equal to the reference signal Vcom to the variable current source 102. The variable current source 102 receives the plural Hall common voltage control signal Vcom_ctrl, and supplies Hall element drive correction currents Ibias1a and Ibias2a respectively adjusted to the two spinning current switches 13 and 14. In short, the two Hall elements 11 and 12 will be driven by the Ibias1a and the Ibias2a.

Specifically, the comparison unit 101 compares the reference signal Vcom with the average common voltage Vhcom_pl, and when Vcom > Vhcom_pl, supplies the Vcom_ctrl to the variable current source 102 so as to increase the Vhcom_pl. The variable current source 102 increases the Ibias1a and the Ibias2a. Additionally, when Vcom < Vhcom_pl, the comparison unit 101 supplies the Vcom_ctrl to the variable current source 102 so as to reduce the Vhcom_pl. The variable current source 102 reduces the Ibias1a and the Ibias2a.

Since the Hall signal feedback network 31 is thus formed, the Hall common voltages Vhcom1 and Vhcom2 of the plurality of Hall elements 11 and 12 can be matched with the reference signal Vcom even when there is influence of process gradients by which the respective Hall common voltages Vhcom1 and Vhcom2 of the plurality of Hall elements 11 and 12 are differentiated. Thus, DC potentials of input signals to the first and the second Gm amplifiers Gm1 and Gm2 that receive the differential signals from the respective Hall elements 11 and 12 can be matched. In short, operating points of the first and the second Gm amplifiers Gm1 and Gm2 can be matched. Accordingly, the gm values of the first and the second Gm amplifiers Gm1 and Gm2 are always equal, thus allowing prevention of cancellation failure due to spike signals having reverse polarities in the addition node 24 to which the output terminals of the first and the second Gm amplifiers Gm1 and Gm2 are connected, so that variations of the first spike in output can be suppressed.

Additionally, as described above, the feedback Gm amplifier Gmfb is also controlled by the same reference signal Vcom. Accordingly, the gm values gm1 and gm2 of the first and the second Gm amplifiers Gm1 and Gm2 and the gm value gmfb of the feedback Gm amplifier Gmfb are controlled by the same signal, and therefore are the same in operating point. In other words, a ratio between the gm values gm1 and gm2 of the first and the second Gm amplifiers Gm1 and Gm2 and the gm value gmfb of the feedback Gm amplifier Gmfb is stable . Accordingly, variations of the second spike signal in output can be suppressed.

As described hereinabove, the Hall electromotive force signal detection circuit of the first embodiment can suppress variations of the spike-like error signals that become obstacles to high-precision detection of a Hall electromotive force signal in the Hall electromotive force signal detection circuit using the plurality of Hall elements 11 and 12 driven by the spinning current techniques and the plurality of transconductance amplifiers.

In addition, in the first embodiment, since the ratio between the gm values gm1 and gm2 of the first and the second Gm amplifiers and the gm value gmfb of the feedback Gm amplifier Gmfb is stable, the gain (gain) of the Hall electromotive force signal detection circuit represented by formula (4) is also stable, so that an effect of reducing gain errors can also be obtained.

Additionally, while the description of the first embodiment has described the case in which the plural Hall common voltage control unit 31b includes each one of the comparison unit 101 and the variable current source 102, this is merely illustrative. The plural Hall common voltage control unit 31b may include each one of the comparison unit 101 and the variable current source 102 in order to supply the Hall element drive correction current Ibias1a, and may include each one of another comparison unit 101 and another variable current source 102 in order to supply the Hall element drive correction current Ibias2a.

Additionally, while the description of the first embodiment has described the simple example that is calculating the average common voltage Vhcom_pl by receiving the positive phase component of the differential signal A1 and the positive phase component of the differential signal A2, this is merely illustrative. For example, a first Hall common voltage calculation unit to which the positive phase component and the negative phase component of a differential signal output from a first spinning current switch are input and a second Hall common voltage calculation unit to which the positive phase component and the negative phase component of a differential signal output from a second spinning current switch are input may be provided, the respective calculated Hall common voltages may be compared with the reference voltage Vcom, and the respective Hall element drive correction currents may be supplied to the respective Hall elements.

Here, in the first embodiment, the first spinning current switch 13 corresponds to a first drive current supply unit, the second spinning current switch 14 corresponds to a second drive current supply unit, the Hall signal feedback network 31 corresponds to a first feedback control unit, and the output signal feedback network 20 corresponds to a feedback unit. Additionally, the feedback chopper switch 21 corresponds to a modulation switch, the addition node 24 corresponds to a current addition unit, the chopper switch 18 corresponds to a demodulation switch, and the feedback network controller 32 corresponds to a reference signal generation circuit.

(Second Embodiment)

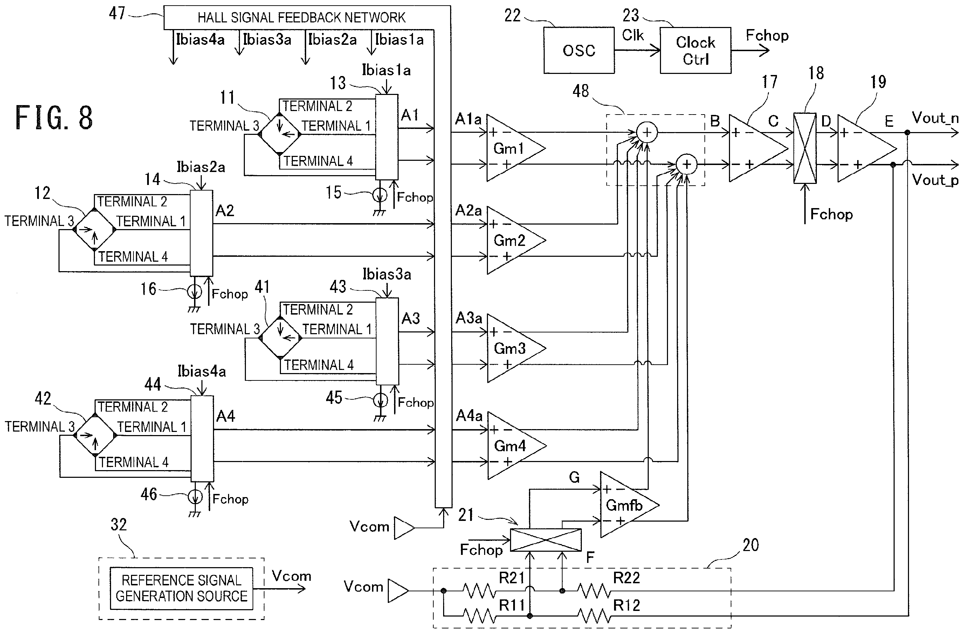

FIG. 8 is a block diagram depicting one example of the structure of a Hall electromotive force signal detection circuit according to a second embodiment of the invention.

The Hall electromotive force signal detection circuit of FIG. 8 includes the first Hall element 11, the second Hall element 12, a third Hall element 41, and a fourth Hall element 42 each including the four terminals (terminal 1, terminal 2, terminal 3, and terminal 4), the first spinning current switch 13, the second spinning current switch 14, a third spinning current switch 43, a fourth spinning current switch 44, the first Hall element drive current source 15, the second Hall element drive current source 16, a third Hall element drive current source 45, and a fourth Hall element drive current source 46. Furthermore, the Hall electromotive force signal detection circuit is formed by including a Hall signal feedback network 47, the first Gm amplifier Gm1, the second Gm amplifier Gm2, a third Gm amplifier Gm3, a fourth Gm amplifier Gm4, the feedback Gm amplifier Gmfb, the amplification stage 17, the chopper switch 18, the output stage 19, the output signal feedback network 20, a feedback chopper switch 21, an oscillator (OSC) 22, the chopper clock generator 23, and the feedback network controller 32. Current values of the first through the fourth Hall element drive current sources 15, 16, 45, and 46 are Ibias1, Ibias2, Ibias3, and Ibias4, respectively.

The feedback network controller 32 includes, for example, a reference signal generation source, and is formed by using, for example, a constant voltage circuit (a regulator circuit) stable against temperature. The feedback network controller 32 generates a reference signal Vcom including a voltage signal.

The Hall electromotive force signal detection circuit of the second embodiment depicted in FIG. 8 is different from the Hall electromotive force signal detection circuit of the first embodiment depicted in FIG. 6 in that the former further includes the third Hall element 41, the fourth Hall element 42, the third spinning current switch 43, the fourth spinning current switch 44, the third Hall element drive current source 45, the fourth Hall element drive current source 46, the third Gm amplifier Gm3, and the fourth Gm amplifier Gm4.

The output signal of the chopper clock generator 23, i.e., the chopper clock Fchop is supplied to the first through the fourth spinning current switches 13, 14, 43, and 44, the chopper switch 18, and the feedback chopper switch 21, and each of these units performs switching of each switch according to the phases $\varphi1$ and $\varphi2$ of the chopper clock Fchop. The four terminals, i.e., the terminal 1, the terminal 2, the terminal 3, and the terminal 4 each included in the first through the fourth Hall elements 11, 12, 41, and 42 are connected to the first through the fourth spinning current switches 13, 14, 43, and 44, respectively.

In addition, the first through the fourth Hall element drive current sources 15, 16, 45, and 46 are connected to the first through the fourth spinning current switches 13, 14, 43, and 44, respectively. Additionally, Hall element drive correction currents Ibias1a, Ibias2a, Ibias3a, and Ibias4a are supplied from the Hall signal feedback network 47 to the first through the fourth spinning current switches 13, 14, 43, and 44, respectively.

With the structure thus formed, the first through the fourth Hall elements 11, 12, 41, and 42 are driven by the first through the fourth spinning current switches 13, 14, 43, and 44, respectively.

Then, the first spinning current switch 13 drives the first Hall element 11 by the above-described first spinning current technique, i.e., by switching the drive current for the first Hall element 11 between the 0-degree direction and the 90-degree direction. The second spinning current switch 14 drives the second Hall element 12 by the above-described second spinning current technique, i.e., by switching the drive current for the second Hall element 12 between the 270-degree direction and the 180-degree direction. Additionally, the third spinning current switch 43 drives the third Hall element 41 by the first spinning current technique, and the fourth spinning current switch 44 drives the fourth Hall element 42 by the second spinning current technique. In other words, operations of the first spinning current switch 13 and the third spinning current switch 43 are equal. Additionally, operations of the second spinning current switch 14 and the fourth spinning current switch 44 are equal.

By driving in this manner, the first spinning current switch 13 supplies the differential signal A1 (indicated by A1 in FIG. 8) including a Hall electromotive force signal from the first Hall element 11 to the Hall signal feedback network 47. Similarly, the second spinning current switch 14 supplies the differential signal A2 (indicated by A2 in FIG. 8) including a Hall electromotive force signal from the second Hall element 12 to the Hall signal feedback network 47. Similarly, the third spinning current switch 43 supplies a differential signal A3 (indicated by A3 in FIG. 8) including a Hall electromotive force signal from the third Hall element 41 to the Hall signal feedback network 47. Similarly, the fourth spinning current switch 44 supplies a differential signal A4 (indicated by A4 in FIG. 8) including a Hall electromotive force signal from the fourth Hall element 42 to the Hall signal feedback network 47.

The Hall signal feedback network 47 receives the differential signal A1, the differential signal A2, the differential signal A3, the differential signal A4, and the reference signal Vcom from the feedback network controller 32, and supplies a first Hall element drive correction current Ibias1a, a second Hall element drive correction current Ibias2a, a third Hall element drive correction current Ibias3a, and a fourth Hall element drive correction current Ibias4a to the first through the fourth spinning current switches 13, 14, 43, and 44, respectively. Additionally, the Hall signal feedback network 47 supplies the differential signal A1 directly as the differential signal A1a to the first Gm amplifier Gm1, supplies the differential signal A2 directly as the differential signal A2a to the second Gm amplifier Gm2, supplies the differential signal A3 directly as a differential signal A3a to the third Gm amplifier Gm3, and supplies the differential signal A4 directly as a differential signal A4a to the fourth Gm amplifier Gm4.

Here, in the description of the second embodiment, the reference signal Vcom output by the feedback network controller 32 is, for example, VDD/2 where VDD represents a power supply voltage that is supplied to the Hall electromotive force signal detection circuit.

In the differential signals A1 and A3 including the positive phase components and the negative phase components thereof, generated spikes have the same polarity with respect to the phase of the chopper clock Fchop. In addition, in the differential signals A2 and A4 also, similarly, generated spikes have the same polarity (reverse polarity to that of the differential signals A1 and A3).

Then, the first through the fourth Gm amplifiers Gm1 through Gm4, respectively, convert the differential signals A1a to A4a from voltage to current, and the feedback Gm amplifier Gmfb converts the differential signal G from voltage to current. Output ends of the first through the fourth Gm amplifiers Gm1 through Gm4 and the feedback Gm amplifier Gmfb are connected to an addition node 48, and the converted current signals are all added together to create a differential signal B (indicated by B in FIG. 8).

Operations of components other than those described above such as the oscillator 22, the chopper clock generator 23, the amplification stage 17, the chopper switch 18, the output stage 19, the output signal feedback network 20, the feedback chopper switch 21, and the feedback network controller 32 are the same as those in the first embodiment, and thus descriptions thereof will be omitted.

The Hall electromotive force signal detection circuit of the second embodiment has the structure described above. As a result, when the resistors R11, R12, R21, and R22 included in the output signal feedback network 20 are defined as R11 = R12 and R21 = R22, the output signal Vout of the Hall electromotive force signal detection circuit is represented by the following formula (8) using the gm values gm1, gm2, gm3, and gm4 of the first through the fourth Gm amplifiers Gm1 through Gm4 and the gm value gmfb of the feedback Gm amplifier Gmfb:

$$
\begin{aligned}
\text{Vout} = \{1 + (\text{R12/R11})\} \times \{&(\text{gm1/gmfb}) \times \text{Vhall1} \\
&+ (\text{gm2/gmfb}) \times \text{Vhall2} + (\text{gm3/gmfb}) \\
&\times \text{Vhall3} + (\text{gm4/gmfb}) \times \text{Vhall4}\} \quad \text{.........} \quad (8)
\end{aligned}
$$

In formula (8), the Vhall3 and the Vhall4, respectively, represent signal voltages of the differential signals A3 and A4.

Here, when the gm values of the respective Gm amplifiers are defined as being gm1 = gm2 = gm3 = gm4 (= gm_hall), formula (8) is represented by the following formula (9):

$$\text{Vout} = (1 + \text{R12/R11}) \times \{(\text{gm\_hall/gmfb})$$

$$\times (\text{Vhall1} + \text{Vhall2} + \text{Vhall3} + \text{Vhall4})\} \quad\text{.....................} \quad (9)$$

In addition, the feedback Gm amplifier Gmfb has the same function as that of the feedback Gm amplifier Gmfb of FIG. 6 in the first embodiment, and the differential signal G is input thereto. Thus, the operating point and the gm value gmfb thereof are determined by the reference signal Vcom.

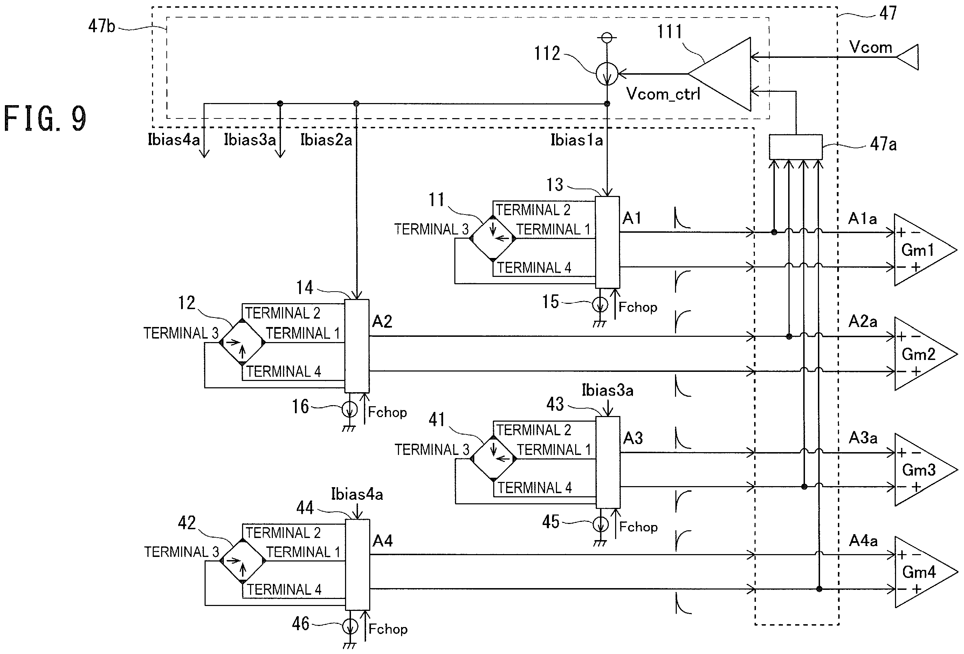

FIG. 9 is a diagram for illustrating the structure of the Hall signal feedback network 47 depicted in FIG. 8.

The Hall signal feedback network 47 in the second embodiment includes a plural Hall common voltage calculation unit 47a and a plural Hall common voltage control unit 47b, and additionally, the plural Hall common voltage control unit 47b includes a comparison unit 111 and a variable current source 112.

The Hall signal feedback network 47 of the second embodiment is different from the Hall signal feedback network 31 in the first embodiment depicted in FIG. 7 in that the plural Hall common voltage calculation unit 47a included in the Hall signal feedback network 47 in the second embodiment receives the positive phase component of the differential signal A1, the positive phase component of the differential signal A2, the negative phase component of the differential signal A3, and the negative phase component of the differential signal A4, calculates the average common voltage Vhcom_pl of the plurality of Hall elements 11, 12, 41, and 42, and supplies it to the comparison unit 111 of the plural Hall common voltage control unit 47b.

The plural Hall common voltage calculation unit 47a is thus formed. Accordingly, when the positive phase components of the differential signals A1 and A2, respectively, are represented by Va1_p and Va2_p and the negative phase components of the differential signals A3 and A4, respectively, are represented by Va3_n and Va4_n, these can be represented by the following formula (10). In addition, Hall common voltages of the first through the fourth Hall elements 11, 12, 41, and 42, respectively, are represented by Vhcom1, Vhcom2, Vhcom3, and Vhcom4, and a spike component superimposed on the respective components is represented by Vspike. When considering the polarity of the spike component Vspike, the components can be represented by the following formula (10):

$$\text{Va1\_p} = \text{Vhcom1} + \text{Vspike} + \text{Vsig(B)}$$

$$\text{Va2\_p} = \text{Vhcom2} - \text{Vspike} + \text{Vsig(B)}$$

$$\text{Va3\_n} = \text{Vhcom3} - \text{Vspike} - \text{Vsig(B)}$$

$$\text{Va4\_n} = \text{Vhcom4} + \text{Vspike} - \text{Vsig(B)}$$

$$\text{.............................} \quad (10)$$

Here, the average common voltage Vhcom_pl of the plurality of Hall elements 11, 12, 41, and 42 can be represented by the following formula (11):

$$\text{Vhcom\_pl} = (\text{Va1\_p} + \text{Va2\_p} + \text{Va3\_n} + \text{Va4\_n})/4$$

$$= (\text{Vhcom1} + \text{Vhcom2} + \text{Vhcom3} + \text{Vhcom4})/4$$

$$\text{...............} \quad (11)$$

In short, the average common voltage Vhcom_pl is an average value of the Hall common voltages of the Hall elements 11, 12, 41, and 42. Here, spike components and the Hall electromotive force signal component Vsig (B) have been cancelled. In other words, influence of the spike components generated in the signals after having been output from the respective spinning current switches 13, 14, 43, and 44 has been eliminated by the plural Hall common voltage calculation unit 47a. Additionally, unlike the Hall signal feedback network 31 depicted in FIG. 7 of the first embodiment, the Hall electromotive force signal component Vsig(B) has been cancelled, so that the Hall common voltages can be more precisely detected.

Specifically, the plural Hall common voltage calculation unit 47a detects the average common voltage Vhcom_pl by correction (arithmetic averaging) of the positive phase components (the in-phase components) of the respective differential outputs of the first spinning current switch 13 and the second spinning current switch 14 and the negative phase components (the different in-phase components) of the respective differential outputs of the third spinning current switch 43 and the fourth spinning current switch 44.

Operations of the comparison unit 111 and the variable current source 112 depicted in FIG. 9 are the same as those of the comparison unit 101 and the variable current source 102 of the Hall signal feedback network 31 in the first embodiment depicted in FIG. 7 except that the variable current source 112 depicted in FIG. 9 supplies the Hall element drive correction currents Ibias1a to Ibias4a to the first through the fourth spinning current switches 13, 14, 43, and 44, respectively.

Since the Hall signal feedback network 47 is thus formed, the Hall common voltages of the plurality of Hall elements 11, 12, 41, and 42 can be matched with the reference voltage Vcom even when there is influence of process gradients by which the respective Hall common voltages Vhcom1, Vhcom2, Vhcom3, and Vhcom4 of the plurality of Hall elements 11, 12, 41, and 42 are differentiated. Thus, operating points of the first through the fourth Gm amplifiers Gm1 through Gm4 that receive the differential signals from the respective Hall elements can be matched. Accordingly, the gm values of the first through the fourth Gm amplifiers are always equal, thus allowing prevention of cancellation failure due to spike signals having reverse polarities in the addition node 48 to which the output terminals of the first through the fourth Gm amplifiers Gm1 through Gm4 are connected, as a result of which variations of the first spike in the output signal Vout can be suppressed.

In addition, as described above, the feedback Gm amplifier Gmfb is also controlled by the same reference signal Vcom. Accordingly, since the gm values gm1, gm2, gm3, and gm4 of the first through the fourth Gm amplifiers Gm1 through Gm4 and the gm value gmfb of the feedback Gm amplifier Gmfb are controlled by the same signal, the ratio between the gm values of the first through the fourth Gm amplifiers Gm1 through Gm4 and the gm value gmfb of the feedback Gm amplifier Gmfb is stabilized.

Accordingly, variations of the second spike signal in the output signal Vout can also be suppressed.

As described hereinabove, the Hall electromotive force signal detection circuit of the second embodiment can suppress variations of spike-like error signals that become obstacles to high-precision detection of Hall electromotive force signals in the Hall electromotive force signal detection circuit using the plurality of Hall elements 11, 12, 41, and 42 driven by the spinning current techniques and the plurality of transconductance amplifiers.

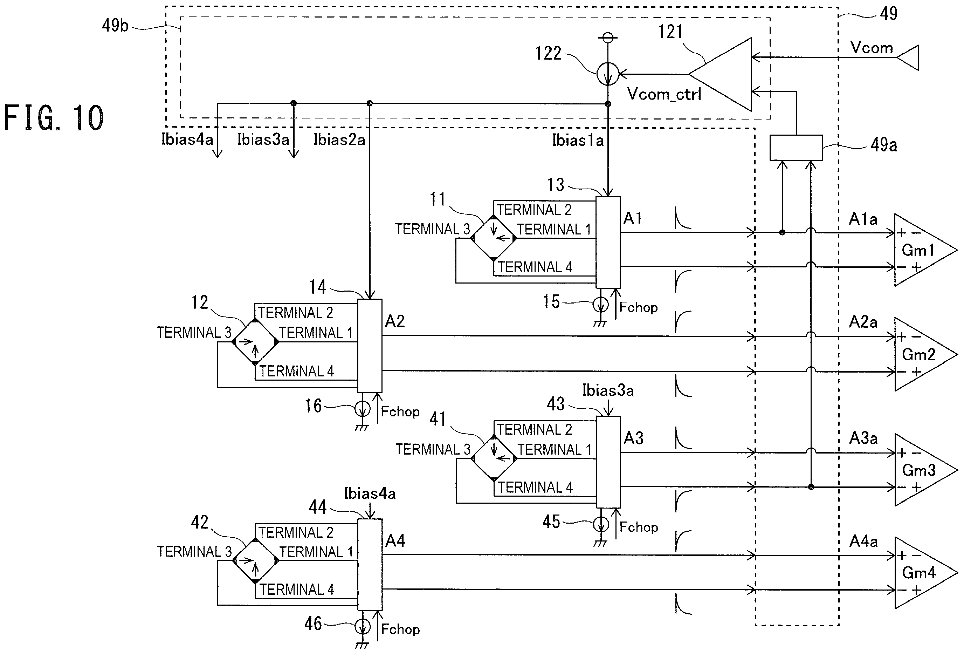

In the second embodiment, instead of the Hall signal feedback network 47 depicted in FIG. 9, a Hall signal feedback network 49 depicted in FIG. 10 may be used.

The Hall signal feedback network 49 depicted in FIG. 10 includes a plural Hall common voltage calculation unit 49a and a plural Hall common voltage control unit 49b. The plural Hall common voltage control unit 49b includes a comparison unit 121 and a variable current source 122.

Unlike the plural Hall common voltage calculation unit 47a in the Hall signal feedback network 47 depicted in FIG. 9, the plural Hall common voltage calculation unit 49a receives the positive phase component of the differential signal A1 and the negative phase component of the differential signal A3, calculates the average common voltage Vhcom_pl of the plurality of Hall elements, i.e., the Hall elements 11 and 41, and supplies it to the comparison unit 121 of the plural Hall common voltage control unit 49b.

In other words, the positive phase component $Va1\_p$ of the differential signal A1 and the negative phase component $Va3\_n$ of the differential signal A3 can be represented by the following formula (12), so that the average common voltage Vhcom_pl can be represented by the following formula (13):

$$Va1\_p = Vhcom1 + Vspike + Vsig(B)$$

$$Va3\_n = Vhcom3 - Vspike - Vsig(B)$$

$$\cdots\cdots\cdots\cdots (12)$$

$$Vhcom\_pl = (Vhcom1 + Vhcom3)/2 \cdots\cdots (13)$$

As depicted in formula (13), the spike component and the Hall electromotive force signal component Vsig(B) have been cancelled. The Vsig(B) has been cancelled, and therefore, in this case also, the Hall common voltages can be more accurately detected than the plural Hall common voltage calculation unit 31a in the first embodiment depicted in FIG. 7. However, the Hall signal feedback network 47 of FIG. 9 is more preferable than the Hall signal feedback network 49 of FIG. 10 in that the former allows consideration of the influence of process gradients on the first through the fourth Hall elements 11, 12, 41, and 42.

In addition, in the second embodiment, the ratio between the gm values gm1, gm2, gm3, and gm4 of the first through the fourth Gm amplifiers Gm1 through Gm4 and the gm value gmfb of the feedback Gm amplifier Gmfb is stable. Thus, the gain (gain) of the Hall electromotive force signal detection circuit represented by formula (9) also becomes stable, so that the effect of reducing gain errors can also be obtained.

Additionally, the plural Hall common voltage calculation unit 49a depicted in FIG. 10 calculates the average common voltage Vhcom_pl from the positive phase component Va1_p of the differential signal A1 and the negative phase component Va3_n of the differential signal A3. However, the average common voltage Vhcom_pl may be calculated, for example, by using two signals whose spike components have mutually different polarities, such as the positive phase component of the differential signal A2 and the negative phase component of the differential signal A4.

Additionally, while the description of the second embodiment has described the case in which the plural Hall common voltage control unit 47b includes each one of the comparison unit 111 and the variable current source 112, this is merely illustrative. The comparison unit 111 and the variable current source 112 may be provided for each of the Hall element drive correction currents Ibias1a, Ibias2a, Ibias3a, and Ibias4a.

In addition, while the description of the second embodiment has described the simple example that is calculating the average common voltage Vhcom_pl by receiving the positive phase components of the differential signals A1 and A2 and the negative phase components of the differential signals A3 and A4, this is merely illustrative. For example, a Hall common voltage calculation unit to which the positive phase component and the negative phase component of a differential signal output from a spinning current switch are input may be provided for each of the spinning current switches, the respective calculated Hall common voltages may be compared with the reference voltage Vcom, and the respective Hall element drive correction currents may be supplied to the respective Hall elements.

Here, in the second embodiment, the third spinning current switch 43 corresponds to a third drive current supply unit, the fourth spinning current switch 44 corresponds to a fourth drive current supply unit, the Hall signal feedback network 47 corresponds to a first feedback control unit, and the output signal feedback network 20 corresponds to a feedback unit. Additionally, the feedback chopper switch 21 corresponds to a modulation switch, the addition node 48 corresponds to a current addition unit, the chopper switch 18 corresponds to a demodulation switch, and the feedback network controller 32 corresponds to a reference signal generation circuit.

(Third Embodiment)

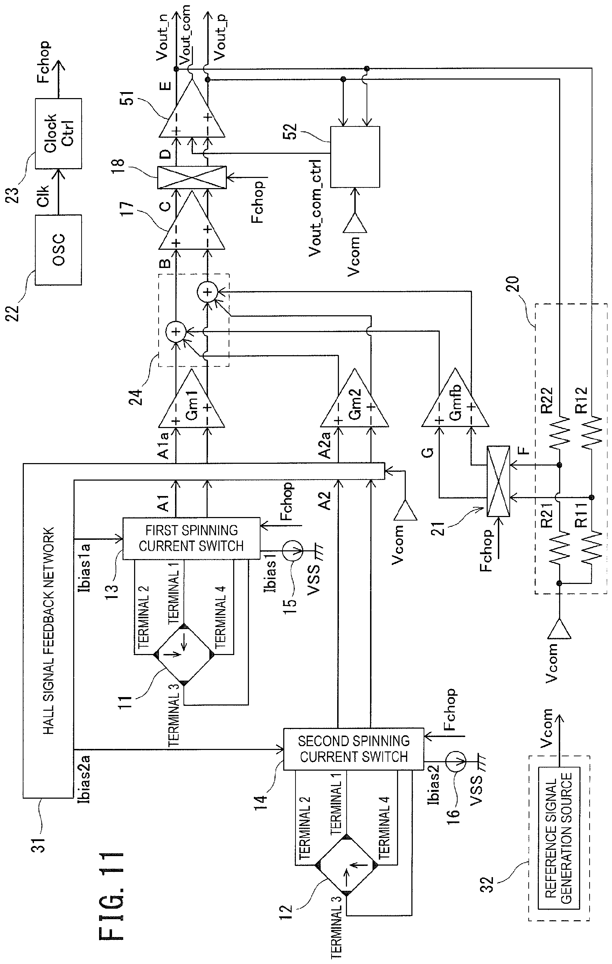

FIG. 11 is a block diagram depicting one example of the structure of the Hall electromotive force signal detection circuit according to a third embodiment of the present invention.

Unlike the Hall electromotive force signal detection circuit of the first embodiment depicted in FIG. 6, the Hall electromotive force signal detection circuit of the third embodiment depicted in FIG. 11 includes an output stage 51 provided with an output common voltage control terminal instead of the output stage 19 included in the Hall electromotive force signal detection circuit depicted in FIG. 6, and further includes a second output signal feedback network 52 different from the output signal feedback network 20.

The second output signal feedback network 52 is formed, for example, by a common mode feedback amplifier. Then, the second output signal feedback network 52 receives the differential signal E and the reference signal Vcom and supplies an output common voltage control signal Vout_com_ctrl to the output stage 51 provided with the output common voltage control terminal. The output stage 51 provided with the output common voltage control terminal receives the output common voltage control signal Vout_com_ctrl and matches the common voltage Vout_com of the differential signal E, i.e. , an intermediate potential of the Vout_p and the Vout_n with the reference signal Vcom.

Specifically, the Hall electromotive force signal detection circuit of FIG. 11 allows the reference signal supplied to the output signal feedback network 20 and the reference signal supplied to the second output signal feedback network 52 to be matched with Vcom, thereby matching the common voltage Vout_com of the differential signal E with the reference signal Vcom.

Here, in the description of the third embodiment, the reference signal Vcom output by the feedback network controller 32 is, for example, VDD/2 where VDD represents a power supply voltage that is supplied to the Hall electromotive force signal detection circuit.

The Hall electromotive force signal detection circuit thus formed can suppress variations of spike-like error signals that become obstacles to high-precision detection of Hall electromotive force signals. Hereinafter, the description thereof will be given.

When there is any mismatching between the resistors R11, R12, R21, and R22 in the output signal feedback network 20 of the Hall electromotive force signal detection circuit of the first embodiment depicted in FIG. 6 or the second embodiment depicted in FIG. 8, i.e., when R11 ≠ R21 and R12 ≠ R22, an offset is generated in the differential signal E. Specifically, offset currents Ioffa and Ioffb are generated from the output terminal of the Hall electromotive force signal detection circuit, i.e., the output terminal of the output stage 19, whereby the offset is generated in the differential signal E. Thus, in order to suppress the generation of the offset currents, when the respective resistance values of the resistors R11, R12, R21, and R22 are made large, a time constant of the signal path of a feedback loop, i.e., the signal path from the differential signal E to the differential signals F, G, B, C, D, and E is increased. As a result, the period of spike generation is extended, thus making a second spike signal large. In other words, since the time constant of the signal path from the differential signal E to the differential signals F, G, B, C, D, and E is proportional to resistance value, the period of spike generation is extended.

Thus, as in the Hall electromotive force signal detection circuit of the third embodiment depicted in FIG. 11, the reference signal supplied to the output signal feedback network 20 and the reference signal supplied to the second output signal feedback network 52 are matched with Vcom, thereby matching the common voltage Vout_com of the differential signal E with the reference signal Vcom. As a result, there is no generation of offset currents that flow from the output terminal of the Hall electromotive force signal detection circuit, i.e., the output terminal of the output stage 19 to the reference signal Vcom, so that the resistance values of the respective resistors R11, R12, R21, and R22 included in the output signal feedback network 20 can be made small. In short, the time constant of the signal path of the feedback loop can be made small.

The cause of generation of the second spike signal is due to the difference between the frequency characteristics of the main signal path, i.e., the signal path from the differential signals A1 and A2 to the differential signals B, C, D, and E and the signal path of the feedback loop, as described above. The main factors that determine the time constant of the main signal path are output resistances of the Hall elements and parasitic capacitances in the spinning current switches, and the main factor that determines the time constant of the signal path of the feedback loop is the resistors R11 and R21 and a parasitic capacitance in the feedback chopper switch 21. In the present embodiment, as described above, it is possible to change the resistance values of the resistors R11 and R21. Then, for example, when the output resistance values of the Hall elements are made equal to the resistance values of the resistors R11 and R21, the time constants of the main signal path and the signal path of the feedback loop can be made small and also can be matched. In short, the generation and variations of the second spike signal can be suppressed.

Additionally, as the second output signal feedback network 52, for example, a common mode feedback circuit can be used. The common mode feedback circuit, i.e., the second output signal feedback network 52 calculates an average value Vout_ave of the Vout_p and the Vout_n of the differential signal E, and outputs such a Vout_com_ctrl that allows the Vout_ave to be matched with the reference signal Vcom.

As described hereinabove, the Hall electromotive force signal detection circuit of the third embodiment can suppress variations of spike-like error signals that become obstacles to high-precision detection of Hall electromotive force signals in the Hall electromotive force signal detection circuit using the plurality of Hall elements driven by the spinning current techniques and the plurality of transconductance amplifiers.

In addition, the Hall electromotive force signal detection circuit of the third embodiment has been described as the case of the Hall electromotive force signal detection circuit of the first embodiment that further includes the output stage 51 provided with the output common voltage control terminal and the second output signal feedback network 52. The same can also be applied to the Hall electromotive force signal detection circuit of the second embodiment. In that case also, the same functions and effects as those in the third embodiment can be obtained.

Here, in the third embodiment, the Hall signal feedback network 31 corresponds to a first feedback control unit, the output signal feedback network 20 corresponds to a feedback unit, and the feedback chopper switch 21 corresponds to a modulation switch. Additionally, the addition node 24 corresponds to a current addition unit, the chopper switch 18 corresponds to a demodulation switch, and the feedback network controller 32 corresponds to a reference signal generation circuit. In addition, the second output signal feedback network 52 corresponds to a second feedback control unit.

(Fourth Embodiment)

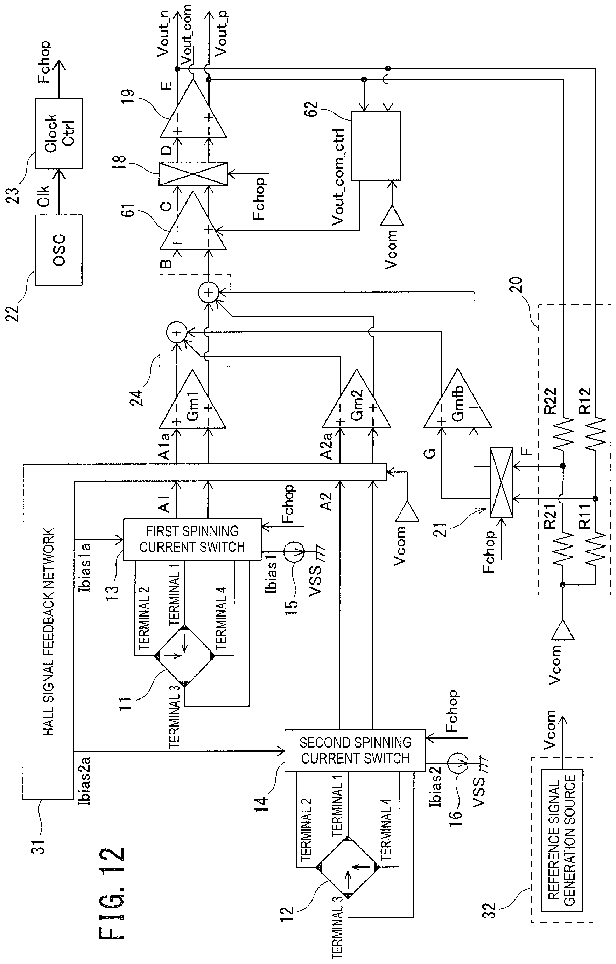

FIG. 12 is a block diagram depicting the structure of a Hall electromotive force signal detection circuit according to a fourth embodiment of the present invention.

Unlike the Hall electromotive force signal detection circuit of the first embodiment depicted in FIG. 6, the Hall electromotive force signal detection circuit of the fourth embodiment includes an amplification stage 61 provided with an output common voltage control terminal instead of the amplification stage 17 depicted in FIG. 6 and a second output signal feedback network 62 different from the output signal feedback network 20.

The second output signal feedback network 62 has the same functional structure as that of the output signal feedback network 52 in the third embodiment, and supplies the output common voltage control signal Vout_com_ctrl to the amplification stage 61 provided with the output common voltage control terminal. The amplification stage 61 provided with the output common voltage control terminal receives the output common voltage control signal Vout_com_ctrl, and supplies the differential signal C to the chopper switch 18 so that the common voltage Vout_com of the differential signal E, i.e., an intermediate potential of the Vout_p and the Vout_n is matched with the reference signal Vcom. The chopper switch 18 receives the differential signal C and supplies a differential signal D demodulated by the chopper clock Fchop to the output stage 19. The output stage 19 receives the differential signal D and outputs the differential signal E in which the common voltage Vout_com has been matched with the Vcom.

Here, in the description of the fourth embodiment, the reference signal Vcom output by the feedback network controller 32 is, for example, VDD/2 where VDD represents a power supply voltage that is supplied to the Hall electromotive force signal detection circuit.

As a result of the structure thus formed, the Hall electromotive force signal detection circuit of the fourth embodiment allows the reference signal supplied to the output signal feedback network 20 and the reference signal supplied to the second output signal feedback network 62 to be matched with the Vcom, as in the Hall electromotive force signal detection circuit of the third embodiment. As a result, the common voltage Vout_com of the differential signal E can be matched with the reference signal Vcom. Thus, due to the same reason as in the third embodiment, variations of spike-like error signals that become obstacles to high-precision detection of Hall electromotive force signals can be suppressed.

In addition, the fourth embodiment has been described as the case of the Hall electromotive force signal detection circuit of the first embodiment that further includes the amplification stage 61 and the second output signal feedback network 62. The same can also be applied to the Hall electromotive force signal detection circuits of the second embodiment and the third embodiment, and in this case also, the same functions and effects as those in the fourth embodiment can be obtained.

Herein, in the fourth embodiment, the Hall signal feedback network 31 corresponds to a first feedback control unit, and the output signal feedback network 20 corresponds to a feedback unit. Additionally, the feedback chopper switch 21 corresponds to a modulation switch, the addition node 24 corresponds to a current addition unit, the chopper switch 18 corresponds to a demodulation switch, and the feedback network controller 32 corresponds to a reference signal generation circuit. In addition, the second output signal feedback network 62 corresponds to a third feedback control unit.

(Fifth Embodiment)

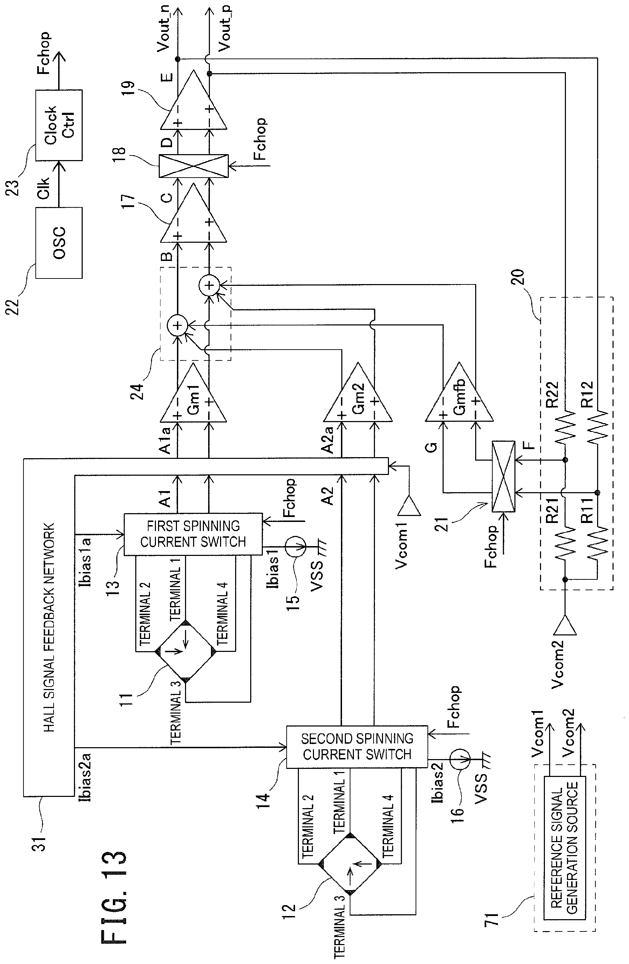

FIG. 13 is a block diagram depicting the structure of a Hall electromotive force signal detection circuit according to a fifth embodiment of the present invention.

Unlike the Hall electromotive force signal detection circuit of the first embodiment depicted in FIG. 6, the Hall electromotive force signal detection circuit of the fifth embodiment includes a feedback network controller 71 as a feedback network controller that supplies a first reference signal Vcom1 to the Hall signal feedback network 31 and supplies a second reference signal Vcom2 to the output signal feedback network 20.

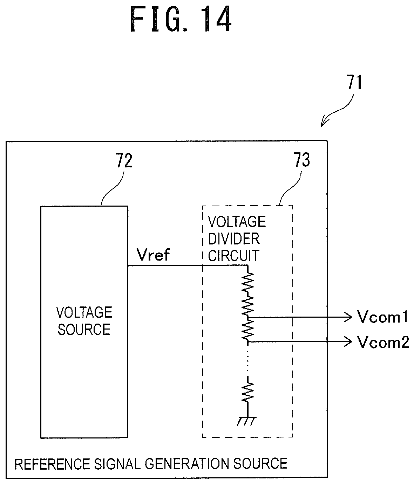

FIG. 14 is a diagram depicting the structure of the feedback network controller 71 in the fifth embodiment of the present invention.

The feedback network controller 71 of FIG. 14 includes a reference signal generation source. The reference signal generation source is formed by, for example, a single voltage source 72 having temperature characteristics and a single voltage divider circuit 73. The voltage divider circuit 73 receives an output voltage Vref of the voltage source 72 and generates the first reference signal Vcom1 and the second reference signal Vcom2 different in voltage level. The voltage source 72 is formed, for example, by using a band gap circuit small in output variation against temperature, or by using a voltage generation circuit in which voltage monotonically decreases or increases with respect to temperature. The voltage divider circuit 73 is formed by, for example, a resistance ladder, and the first reference signal Vcom1 and the second reference signal Vcom2 are generated via resistance division.

Since the feedback network controller 71 is thus formed, the first reference signal Vcom1 and the second reference signal Vcom2 are different in voltage but are the same in temperature variation characteristics.

Since the Hall signal feedback network 31 can match the Hall common voltages Vhcom1 and Vhcom2 of the plurality of Hall elements 11 and 12 with the reference signal Vcom1, DC potentials of input signals to the first and the second Gm amplifiers Gm1 and Gm2 that receive the differential signals from the respective Hall elements 11 and 12 can be matched. In other words, the operating points of the first and the second Gm amplifiers Gm1 and Gm2 can be matched. Accordingly, the gm values of the first and the second Gm amplifiers Gm1 and Gm2 are always equal, thus allowing prevention of cancellation failure due to spike signals having reverse polarities in the addition node 24 connected to the output terminals of the first and the second Gm amplifiers Gm1 and Gm2, so that variations of the first spike in output can be suppressed.

On the other hand, the feedback Gm amplifier Gmfb is controlled by the second reference signal Vcom2. Due to this, the operating points of the first and the second Gm amplifiers Gm1 and Gm2 are different from the operating point of the feedback Gm amplifier Gmfb. However, since the temperature variation characteristics thereof are the same, the temperature variation characteristics of the operating points of the first and the second Gm amplifiers Gm1 and Gm2 are the same as those of the operating point of the feedback Gm amplifier Gmfb. In short, although the operating points are different, temperature-induced variations of the ratio of the gm1 to the gmfb and the ratio of the gm2 to the gmfb are stable. Accordingly, variations of the second spike signal in output can be suppressed.

Additionally, in the fifth embodiment, for example, when the voltage source 72 is formed by using a voltage generation circuit in which voltage monotonically decrease or increase with respect to temperature, the first reference signal Vcom1 and the second reference signal Vcom2 can be caused to monotonically decrease or increase with respect to temperature. Thus, the amount of temperature-induced variations in the operating points can be controlled so that temperature-induced variations of the gm values of the respective Gm amplifiers are cancelled. In such a case also, even when the operating points are different, the temperature-induced variations of the ratio of the gm1 to the gmfb and the ratio of the gm2 to the gmfb can be stabilized. Accordingly, variations of the second spike signal in output can be suppressed.

Additionally, in the fifth embodiment, since the ratio between the gm values gm1 and gm2 of the first and the second Gm amplifiers Gm1 and Gm2 and the gm value gmfb of the feedback Gm amplifier Gmfb is stable, the gain (gain) of the Hall electromotive force signal detection circuit represented by formula (4) is also stable, so that the effect of reducing gain errors can also be obtained.

In addition, the fifth embodiment has described the case of the Hall electromotive force signal detection circuit of the first embodiment in which the reference signal that is supplied to the Hall signal feedback network from the feedback network controller and the reference signal that is supplied to the output signal feedback network therefrom are different in voltage level but are the same in temperature-induced variation characteristics. The same can be applied to the Hall electromotive force signal detection circuits of the second through fourth embodiments, and in this case also, the same functions and effects as those in the fifth embodiment can be obtained.

Here, in the fifth embodiment, the Hall signal feedback network 31 corresponds to a first feedback control unit, the output signal feedback network 20 corresponds to a feedback unit, and the feedback chopper switch 21 corresponds to a modulation switch. Additionally, the addition node 24 corresponds to a current addition unit, the chopper switch 18 corresponds to a demodulation switch, and the feedback network controller 71 corresponds to a reference signal generation circuit.

As described hereinabove, according to the present invention, in the Hall electromotive force signal detection circuit driving the plurality of Hall elements by the spinning current techniques, and using the plurality of transconductance amplifiers, the Hall signal feedback network is prepared, and the reference signal is supplied from the feedback network controller to the Hall signal feedback network and the output signal feedback network, thereby suppressing variations of spike signals. In addition, in another aspect, furthermore, the reference signal is supplied from the feedback network controller to the second output signal feedback network, thereby suppressing variations of spike signals. Additionally, in another aspect, the first reference signal and the second reference signal having the same temperature-induced variation characteristics are supplied from the feedback network controller to the Hall signal feedback network and the output signal feedback network, respectively, thereby suppressing variations of spike signals.

In addition, in the description of the embodiments of the present invention hereinabove, the spinning current technique for driving the Hall elements has been described as a combination of the first spinning current technique of switching the drive current direction between the 0-degree direction and the 90-degree direction and the second spinning current technique of switching the drive current direction between the 270-degree direction and the 180-degree direction. However, obviously, the invention can be implemented without being limited to the combination of the techniques. The combination is acceptable as long as it is a combination in which spikes generated by spinning current techniques for driving Hall elements have mutually reverse polarities. For example, in the first Hall element, the drive current direction may be switched in order of the 0-degree direction, the 90-degree direction, the 270-degree direction, and the 180-degree direction, and in the second Hall element, the drive current direction may be switched in order of the 270-degree direction, the 180-degree direction, the 0-degree direction, and the 90-degree direction.

Additionally, all of the embodiments have been described as the case in which the direction of incidence of magnetic flux density to all the Hall elements is the same. However, this is merely illustrative, and the invention can be implemented even in cases in which magnetic flux density is input thereto from mutually different directions. For example, the magnetic flux density may be input to the first Hall element from a front surface of the silicon substrate, and may be input to the second Hall element from a back surface of the silicon substrate. Such a case is also encompassed in the scope of the present invention.

In addition, in all of the embodiments, the reference signal from the feedback network controller may be supplied to the Hall signal feedback network and the output signal feedback network via a buffer amplifier. Additionally, in the third and the fourth embodiments, also, the reference signal may be supplied to the second output signal feedback network via a buffer amplifier.

Additionally, the reference signal from the feedback network controller is the same reference signal as long as the voltage is matching on time average, and even if voltage variations occur due to an instantaneous noise or the like, it can be considered as the same reference signal. In other words, even in the case as mentioned above in which the reference signal is input from the feedback network controller to each feedback network via a circuit such as a buffer amplifier, it can be considered as the same reference signal as long as the input voltage to each feedback network is matching on time average. Additionally, in a case in which input/output signals of the buffer amplifier are controlled to be matched, the input/output signals can be considered as the same reference signal.

In addition, in all of the embodiments, the feedback network controller may supply by additionally superimposing, on the reference signal (the first and the second reference signals in the fifth embodiment), a signal capable of controlling operating points so as to eliminate the influence of variations of the gm values of the plurality of transconductance amplifiers that occur due to stress caused by an IC package to which the Hall electromotive force signal detection circuit is incorporated. Such a modification is also included in the present invention.

Additionally, all of the embodiments of the present invention have been described for the case of using the silicon Hall elements. However, it is also possible to apply Hall elements made of a compound semiconductor such as GaAs or InSb.

In addition, the present invention is not limited to the respective embodiments described hereinabove, and design changes can be made within the scope of the invention as defined by the claims.

Reference Signs List

| | |
|---|---|
| 11, 12, 41, 42 | Hall element |
| 13, 14, 43, 44 | Spinning current switch |
| 15, 16, 45, 46 | Hall element drive current source |
| 17 | Amplification stage |
| 18 | Chopper switch |
| 19, 51 | Output stage |
| 20, 62 | Output signal feedback network |
| 21 | Feedback chopper switch |
| 22 | Oscillator |
| 23 | Chopper clock generator |
| 24, 48 | Addition node |
| 31, 47, 49 | Hall signal feedback network |
| 31a, 47a | Plural Hall common voltage calculation unit |
| 31b, 47b | Plural Hall common voltage control unit |
| 101, 111, 121 | Comparison unit |
| 102, 112, 122 | Variable current source |

**Claims**

1. A Hall electromotive force signal detection circuit comprising:

   a first Hall element (11) including a plurality of terminals;
   a second Hall element (12) including a plurality of terminals;
   a first drive current supply unit (13) configured to supply a drive current to the plurality of terminals of the first Hall element in a first order in order to cause the first Hall element to generate a first Hall electromotive force signal by driving the first Hall element by a spinning current technique;
   a second drive current supply unit (14) configured to, in order to cause the second Hall element to generate a second Hall electromotive force signal by driving the second Hall element by the spinning current technique, supply a drive current to the plurality of terminals of the second Hall element in a second order in which a polarity of a spike component that is superimposed on the second Hall electromotive force signal is reverse to a polarity of a spike component that is superimposed on the first Hall electromotive force signal;
   **characterized by** further comprising:

   a first feedback control unit configured to perform a feedback control so that common voltages of the first and the second Hall electromotive force signals match with a reference voltage;
   a first Gm amplifier configured to convert the first Hall electromotive force signal to a first current;
   a second Gm amplifier configured to convert the second Hall electromotive force signal to a second current;

and
a current addition unit configured to add the first current to the second current,
wherein the Hall electromotive force signal detection circuit is configured to amplify and output an output signal from the current addition unit, and
wherein the spike component is generated by a temporal transition in shifting from bias voltages determined by flow of the drive currents to the Hall elements to voltages of the Hall electromotive force signals.

2. The Hall electromotive force signal detection circuit according to claim 1, further comprising:

a feedback unit configured to feedback a first voltage obtained by dividing a difference between an output voltage and the reference voltage;
a modulation switch configured to modulate the first voltage to generate a second voltage by using a chopping clock;
a feedback Gm amplifier configured to convert the second voltage to a feedback current; and
a demodulation switch configured to demodulate an output signal of the current addition unit by using the chopping clock;
an output stage (19) configured to amplify the signal demodulated by the demodulation switch and to output the signal as the output voltage; and
a reference signal generation circuit configured to generate the reference voltage,
wherein the current addition unit is configured to add the first current, the second current, and the feedback current.

3. The Hall electromotive force signal detection circuit according to claim 2, wherein

the first feedback control unit includes a plural Hall common voltage calculation unit configured to calculate an average common voltage of the first and the second Hall electromotive force signals and a plural Hall common voltage control unit; and
the plural Hall common voltage control unit includes a comparator configured to, according to a result of comparison between the average common voltage calculated by the plural Hall common voltage calculation unit and the reference voltage, output a plural Hall common voltage control signal for matching the average common voltage with the reference voltage and a variable current source configured to, on a basis of the plural Hall common voltage control signal output from the comparator, generate a Hall element drive correction current and to output the Hall element drive correction current to the first drive current supply unit (13) and the second drive current supply unit (14).

4. The Hall electromotive force signal detection circuit according to claim 2, further comprising:

a third Hall element including a plurality of terminals;
a fourth Hall element including a plurality of terminals;
a third drive current supply unit configured to supply a drive current to the plurality of terminals of the third Hall element in the first order in order to cause the third Hall element to generate a third Hall electromotive force signal;
a fourth drive current supply unit configured to supply a drive current to the plurality of terminals of the fourth Hall element in the second order in order to cause the fourth Hall element to generate a fourth Hall electromotive force signal;
a third Gm amplifier configured to convert the third Hall electromotive force signal to a third current; and
a fourth Gm amplifier configured to convert the fourth Hall electromotive force signal to a fourth current,
wherein the first feedback control unit is configured to perform a feedback control so that common voltages of the first, the second, the third, and the fourth Hall electromotive force signals match with the reference voltage; and
wherein the current addition unit is configured to add the first, the second, the third, and the fourth currents to the feedback current.

5. The Hall electromotive force signal detection circuit according to claim 4, wherein

the first feedback control unit includes a plural Hall common voltage calculation unit (31a) configured to calculate an average common voltage of the first, the second, the third, and the fourth Hall electromotive force signals and a plural Hall common voltage control unit; and
the plural Hall common voltage control unit includes a comparator configured to, according to a result of comparison between the average common voltage calculated by the plural Hall common voltage calculation unit and the reference voltage, output a plural Hall common voltage control signal for matching the average common voltage with the reference voltage and a variable current source configured to, on a basis of the plural Hall common voltage control signal output from the comparator, generate a Hall element drive correction current and to output the Hall element drive correction current to the first, the second, the third, and the fourth drive current supply units.

6. The Hall electromotive force signal detection circuit according to claim 4, wherein the first feedback control unit is configured to perform the feedback control on a basis of two signals among the first, the second, the third, and the fourth Hall electromotive force signals, in which polarities of spike components that are superimposed on the two signals are mutually different.

7. The Hall electromotive force signal detection circuit according to any one of claims 2 to 6, further comprising: a second feedback control unit configured to receive the output voltage and the reference voltage and to perform a feedback control so that a common voltage of the output stage (19) matches with the reference voltage.

8. The Hall electromotive force signal detection circuit according to any one of claims 2 to 7, further comprising: an amplification stage (61) configured to convert the output signal of the current addition unit to a voltage, to amplify the voltage, and to output to the demodulation switch.

9. The Hall electromotive force signal detection circuit according to claim 8, wherein the amplification stage includes a common voltage adjustment terminal, and the Hall electromotive force signal detection circuit further comprises a third feedback control unit configured to receive the output voltage and the reference voltage and to feedback a control signal to the common voltage adjustment terminal so that the common voltage of the output stage (19) matches with the reference voltage.

10. The Hall electromotive force signal detection circuit according to claim 1:

wherein the first feedback control unit is configured to perform the feedback control so that common voltages of the first and the second Hall electromotive force signals match with a first reference voltage as the reference voltage,

wherein the Hall electromotive force signal detection circuit further comprises:

a feedback unit configured to feedback a first voltage obtained by dividing a difference between an output voltage and a second reference voltage;

a modulation switch configured to modulate the first voltage by using a chopping clock to generate a second voltage;

a feedback Gm amplifier configured to convert the second voltage to a feedback current;

a demodulation switch configured to demodulate an output signal of the current addition unit by using the chopping clock;

an output stage (19) configured to amplify the signal demodulated by the demodulation switch and to output the signal as the output voltage; and

a reference signal generation circuit configured to generate the first reference voltage and the second reference voltage,

wherein the current addition unit is configured to add the first current, the second current, and the feedback current, and

wherein the first reference voltage and the second reference voltage are generated on a basis of a single voltage source including predetermined output temperature characteristics.

11. The Hall electromotive force signal detection circuit according to claim 10, wherein the output temperature characteristics of the voltage source are constant.

12. The Hall electromotive force signal detection circuit according to claim 1, wherein the first feedback control unit is configured to calculate an average common voltage of the first and the second Hall electromotive force signals and to perform a feedback control on a basis of the calculated average common voltage .

13. A current sensor including the Hall electromotive force signal detection circuit according to any one of claims 1 to 12.

**Patentansprüche**

1.  Elektromotorische Halleffekt-Kraftsignaldetektionsschaltung, umfassend:

    ein erstes Halleffekt-Element (11), das eine Vielzahl von Anschlussklemmen einschließt;
    ein zweites Halleffekt-Element (12), das eine Vielzahl von Anschlussklemmen einschließt;
    eine erste Antriebsstrom-Versorgungseinheit (13), die ausgelegt ist, um einen Antriebsstrom an die Vielzahl von Anschlussklemmen des ersten Halleffekt-Elements in einer ersten Reihenfolge abzugeben, um zu verursachen, dass das Halleffekt-Element durch Antreiben des ersten Halleffekt-Elements durch eine Spinstromtechnik ein erstes elektromotorisches Halleffekt-Kraftsignal erzeugt;
    eine zweite Antriebsstrom-Versorgungseinheit (14), die ausgelegt ist, um zu verursachen, dass das zweite Halleffekt-Element durch Antreiben des zweiten Halleffekt-Elements durch Spinstromtechnik ein zweites elektromotorisches Halleffekt-Kraftsignal erzeugt, einen Antriebsstrom an die Vielzahl von Anschlussklemmen des zweiten Halleffekt-Elements in einer zweiten Reihenfolge abgibt, in der eine Polarität einer Spike-Komponente, die über das zweite elektromotorische Halleffekt-Kraftsignal überlagert ist, die Umkehrung einer Polarität einer Spike-Komponente ist, die über das erste elektromotorische Halleffekt-Kraftsignal überlagert ist;
    **dadurch gekennzeichnet, dass** sie weiter umfasst:

    eine erste Rückmeldungssteuerungseinheit, die ausgelegt ist, um eine Rückmeldungssteuerung so vorzunehmen, dass gemeinsame Spannungen des ersten und des zweiten elektromotorischen Halleffekt-Kraftsignals mit einer Referenzspannung übereinstimmen;
    einen ersten Transkonduktanzverstärker, der ausgelegt ist, um das erste elektromotorische Halleffekt-Kraftsignal in einen ersten Strom umzuwandeln;
    einen zweiten Transkonduktanzverstärker, der ausgelegt ist, um das zweite elektromotorische Halleffekt-Kraftsignal in einen zweiten Strom umzuwandeln; und
    eine Stromadditionseinheit, die ausgelegt ist, um den ersten Strom zu dem zweiten Strom zu addieren, wobei die elektromotorische Halleffekt-Kraftsignaldetektionsschaltung ausgelegt ist, um ein Ausgabesignal aus der Stromadditionseinheit zu verstärken und auszugeben, und
    wobei die Spike-Komponente durch einen temporären Übergang beim Wechseln von Vorspannungen, die durch einen Fluss der Antriebsströme zu den Halleffekt-Elementen bestimmt sind, zu Spannungen der elektromotorischen Halleffekt-Kraftsignale erzeugt wird.

2.  Elektromotorische Halleffekt-Kraftsignaldetektionsschaltung nach Anspruch 1, weiter umfassend:

    eine Rückmeldungseinheit, die ausgelegt ist, um eine erste Spannung zurückzumelden, die durch Dividieren einer Differenz zwischen einer Ausgabespannung und der Referenzspannung erhalten wurde;
    einen Modulationsschalter, der ausgelegt ist, um die erste Spannung zu modulieren, um unter Verwendung einer Taktuhr eine zweite Spannung zu erzeugen;
    einen Rückmeldungs-Transkonduktanzverstärker, der ausgelegt ist, um die zweite Spannung in einen Rückmeldungsstrom umzuwandeln; und
    einen Demodulationsschalter, der ausgelegt ist, um unter Verwendung der Taktuhr ein Ausgabesignal der Stromadditionseinheit zu demodulieren;
    eine Ausgabestufe (19), die ausgelegt ist, um das von dem Demodulationsschalter demodulierte Signal zu verstärken und das Signal als Ausgabespannung auszugeben; und
    eine Schaltung zum Erzeugen von Referenzsignalen, die ausgelegt ist, um die Referenzspannung erzeugen, wobei die Stromadditionseinheit ausgelegt ist, um den ersten Strom, den zweiten Strom und den Rückmeldungsstrom zu addieren.

3.  Elektromotorische Halleffekt-Kraftsignaldetektionsschaltung nach Anspruch 2, wobei
    die erste Rückmeldungssteuerungseinheit eine Einheit zur Berechnung von mehreren gemeinsamen Halleffekt-Spannungen, die ausgelegt ist, um eine durchschnittliche gemeinsame Spannung des ersten und des zweiten elektromotorischen Halleffekt-Kraftsignals zu berechnen, und eine Einheit zur Steuerung von mehreren gemeinsamen Halleffekt-Spannungen einschließt; und
    die Einheit zur Steuerung von mehreren gemeinsamen Halleffekt-Spannungen einen Komparator, der ausgelegt ist, um, gemäß einem Vergleichsergebnis zwischen der von der Einheit zur Berechnung von mehreren gemeinsamen Halleffekt-Spannungen berechneten durchschnittlichen gemeinsamen Spannung und der Referenzspannung, ein Steuerungssignal mehrerer gemeinsamer Halleffekt-Spannungen auszugeben, damit die durchschnittliche gemeinsame Spannung mit der Referenzspannung übereinstimmt, und eine variable Stromquelle, die ausgelegt ist, um auf einer Grundlage der Ausgabe des Steuerungssignals mehrerer gemeinsamer Halleffekt-Spannungen aus dem Komparator einen Antriebskorrekturstrom für Halleffekt-Elemente zu erzeugen und den Antriebskorrekturstrom für Halleffekt-Elemente an die erste Antriebsstrom-Versorgungseinheit (13) und die zweite Antriebsstrom-Versorgungseinheit (14) auszugeben, einschließt.

4. Elektromotorische Halleffekt-Kraftsignaldetektionsschaltung nach Anspruch 2, weiter umfassend:

ein drittes Halleffekt-Element, das eine Vielzahl von Anschlussklemmen einschließt;
ein viertes Halleffekt-Element, das eine Vielzahl von Anschlussklemmen einschließt;
eine dritte Antriebsstrom-Versorgungseinheit, die ausgelegt ist, um einen Antriebsstrom an die Vielzahl von Anschlussklemmen des dritten Halleffekt-Elements in der ersten Reihenfolge abzugeben, um zu verursachen, dass das dritte Halleffekt-Element ein drittes elektromotorisches Halleffekt-Kraftsignal erzeugt;
eine vierte Antriebsstrom-Versorgungseinheit, die ausgelegt ist, um einen Antriebsstrom an die Vielzahl von Anschlussklemmen des vierten Halleffekt-Elements in der zweiten Reihenfolge abzugeben, um zu verursachen, dass das vierte Halleffekt-Element ein viertes elektromotorisches Halleffekt-Kraftsignal erzeugt;
einen dritten Transkonduktanzverstärker, der ausgelegt ist, um das dritte elektromotorische Halleffekt-Kraftsignal in einen dritten Strom umzuwandeln; und
einen vierten Transkonduktanzverstärker, der ausgelegt ist, um das vierte elektromotorische Halleffekt-Kraftsignal in einen vierten Strom umzuwandeln,
wobei die erste Rückmeldungssteuerungseinheit ausgelegt ist, um eine Rückmeldungssteuerung so vorzunehmen, dass gemeinsame Spannungen des ersten, des zweiten, des dritten und des vierten elektromotorischen Halleffekt-Kraftsignals mit der Referenzspannung übereinstimmen; und
wobei die Stromadditionseinheit ausgelegt ist, um den ersten, den zweiten, den dritten und den vierten Strom mit dem Rückmeldungsstrom zu addieren.

5. Elektromotorische Halleffekt-Kraftsignaldetektionsschaltung nach Anspruch 4, wobei
die erste Rückmeldungssteuerungseinheit eine Einheit zur Berechnung von mehreren gemeinsamen Halleffekt-Spannungen (31a), die ausgelegt ist, um eine durchschnittliche gemeinsame Spannung des ersten, des zweiten, des dritten und des vierten elektromotorischen Halleffekt-Kraftsignals zu berechnen, und eine Einheit zur Steuerung von mehreren gemeinsamen Halleffekt-Spannungen einschließt; und
die Einheit zur Steuerung von mehreren gemeinsamen Halleffekt-Spannungen einen Komparator, der ausgelegt ist, um, gemäß einem Vergleichsergebnis zwischen der von der Einheit zur Berechnung von mehreren gemeinsamen Halleffekt-Spannungen berechneten durchschnittlichen gemeinsamen Spannung und der Referenzspannung, ein Steuerungssignal mehrerer gemeinsamer Halleffekt-Spannungen auszugeben, damit die durchschnittliche gemeinsame Spannung mit der Referenzspannung übereinstimmt, und eine variable Stromquelle, die ausgelegt ist, um auf einer Grundlage der Ausgabe des Steuerungssignals mehrerer gemeinsamer Halleffekt-Spannungen aus dem Komparator einen Antriebskorrekturstrom für Halleffekt-Elemente zu erzeugen und den Antriebskorrekturstrom für Halleffekt-Elemente an die erste, die zweite, die dritte und die vierte Antriebsstrom-Versorgungseinheit auszugeben, einschließt.

6. Elektromotorische Halleffekt-Kraftsignaldetektionsschaltung nach Anspruch 4, wobei
die erste Rückmeldungssteuerungseinheit ausgelegt ist, um die Rückmeldungssteuerung auf einer Grundlage von zwei Signalen unter dem ersten, dem zweiten, dem dritten und dem vierten elektromotorischen Halleffekt-Kraftsignal vorzunehmen, bei dem Polaritäten von Spike-Komponenten, die über die zwei Signale überlagert sind, untereinander unterschiedlich sind.

7. Elektromotorische Halleffekt-Kraftsignaldetektionsschaltung nach einem der Ansprüche 2 bis 6, weiter umfassend:
eine zweite Rückmeldungssteuerungseinheit, die ausgelegt ist, um die Ausgabespannung und die Referenzspannung zu empfangen und eine Rückmeldungssteuerung so vorzunehmen, dass eine gemeinsame Spannung der Ausgabestufe (19) mit der Referenzspannung übereinstimmt.

8. Elektromotorische Halleffekt-Kraftsignaldetektionsschaltung nach einem der Ansprüche 2 bis 7, weiter umfassend:
eine Verstärkungsstufe (61), die ausgelegt ist, um das Ausgabesignal der Stromadditionseinheit in eine Spannung umzuwandeln, die Spannung zu verstärken und an den Demodulationsschalter auszugeben.

9. Elektromotorische Halleffekt-Kraftsignaldetektionsschaltung nach Anspruch 8, wobei die Verstärkungsstufe eine Anschlussklemme zur Anpassung von gemeinsamer Spannung einschließt und die elektromotorische Halleffekt-Kraftsignaldetektionsschaltung weiter eine dritte Rückmeldungssteuerungseinheit umfasst, die ausgelegt ist, um die Ausgabespannung und die Referenzspannung zu empfangen und ein Steuerungssignal an die Anschlussklemme zur Anpassung von gemeinsamer Spannung so zurückzumelden, dass die gemeinsame Spannung der Ausgabestufe (19) mit der Referenzspannung übereinstimmt.

**10.** Elektromotorische Halleffekt-Kraftsignaldetektionsschaltung nach Anspruch 1:

wobei die erste Rückmeldungssteuerungseinheit ausgelegt ist, um die Rückmeldungssteuerung so vorzunehmen, dass gemeinsame Spannungen des ersten und des zweiten elektromotorischen Halleffekt-Kraftsignals mit einer ersten Referenzspannung als Referenzspannung übereinstimmen,
wobei die elektromotorische Halleffekt-Kraftsignaldetektionsschaltung weiter umfasst:

eine Rückmeldungseinheit, die ausgelegt ist, um eine erste, durch Teilen einer Differenz zwischen einer Ausgabespannung und einer zweiten Referenzspannung erhaltene, Spannung zurückzumelden;
einen Modulationsschalter, der ausgelegt ist, um unter Verwendung einer Taktuhr die erste Spannung zu modulieren, um eine zweite Spannung zu erzeugen;
einen Rückmeldungs-Transkonduktanzverstärker, der ausgelegt ist, um die Spannung in einen Rückmeldungsstrom umzuwandeln;
einen Demodulationsschalter, der ausgelegt ist, um unter Verwendung der Taktuhr ein Ausgabesignal der Stromadditionseinheit zu demodulieren;
eine Ausgabestufe (19), die ausgelegt ist, um das von dem Demodulationsschalter demodulierte Signal zu verstärken und das Signal als die Ausgabespannung auszugeben; und
eine Schaltung zum Erzeugen von Referenzsignalen, die ausgelegt ist, um die erste Referenzspannung und die zweite Referenzspannung zu erzeugen,
wobei die Stromadditionseinheit ausgelegt ist, um den ersten Strom, den zweiten Strom und den Rückmeldungsstrom zu addieren, und
wobei die erste Referenzspannung und die zweite Referenzspannung auf einer Grundlage einer einzigen Spannungsquelle erzeugt werden, die vorbestimmte Ausgabetemperaturmerkmale einschließt.

**11.** Elektromotorische Halleffekt-Kraftsignaldetektionsschaltung nach Anspruch 10, wobei die Ausgabetemperaturmerkmale der Spannungsquelle konstant sind.

**12.** Elektromotorische Halleffekt-Kraftsignaldetektionsschaltung nach Anspruch 1, wobei
die erste Rückmeldungssteuerungseinheit ausgelegt ist, um eine durchschnittliche gemeinsame Spannung des ersten und des zweiten elektromotorischen Halleffekt-Kraftsignals zu berechnen und eine Rückmeldungssteuerung auf einer Grundlage der berechneten durchschnittlichen gemeinsamen Spannung vorzunehmen.

**13.** Stromsensor, der die elektromotorische Halleffekt-Kraftsignaldetektionsschaltung nach einem der Ansprüche 1 bis 12 einschließt.

**Revendications**

**1.** Circuit de détection de signal de force électromotrice à effet Hall comprenant :

un premier élément à effet Hall (11) incluant une pluralité de bornes ;
un deuxième élément à effet Hall (12) incluant une pluralité de bornes ;
une première unité d'alimentation en courant d'attaque (13) configurée pour fournir un courant d'attaque à la pluralité de bornes du premier élément à effet Hall dans un premier ordre afin d'amener le premier élément à effet Hall à générer un premier signal de force électromotrice à effet Hall en excitant le premier élément à effet Hall par une technique à courant tournant ;
une deuxième unité d'alimentation en courant d'attaque (14) configurée pour fournir, afin d'amener le deuxième élément à effet Hall à générer un deuxième signal de force électromotrice à effet Hall en excitant le deuxième élément à effet Hall par la technique à courant tournant, un courant d'attaque à la pluralité de bornes du deuxième élément à effet Hall dans un second ordre dans lequel une polarité d'un composant de pointe qui est superposé sur le deuxième signal de force électromotrice à effet Hall, est inverse à une polarité d'un composant de pointe qui est superposé sur le premier signal de force électromotrice à effet Hall ;
**caractérisé en ce qu'**il comprend en outre :

une première unité de commande de rétroaction configurée pour effectuer une commande de rétroaction de telle sorte que des tensions communes des premier et deuxième signaux de force électromotrice à effet Hall correspondent à une tension de référence ;

un premier amplificateur Gm configuré pour convertir le premier signal de force électromotrice à effet Hall en un premier courant ;

un deuxième amplificateur Gm configuré pour convertir le deuxième signal de force électromotrice à effet Hall en un deuxième courant ; et

une unité d'ajout de courant configurée pour ajouter le premier courant au deuxième courant,

dans lequel le circuit de détection de signal de force électromotrice à effet Hall est configuré pour amplifier et émettre un signal de sortie à partir de l'unité d'ajout de courant, et

dans lequel le composant de pointe est généré par une transition temporelle lors du passage de tensions de polarisation déterminées par une circulation des courants d'attaque dans les éléments à effet Hall à des tensions des signaux de force électromotrice à effet Hall.

2. Circuit de détection de signal de force électromotrice à effet Hall selon la revendication 1, comprenant en outre :

une unité de rétroaction configurée pour réaliser une rétroaction sur une première tension obtenue en divisant une différence entre une tension de sortie et la tension de référence ;

un commutateur de modulation configuré pour moduler la première tension pour générer une seconde tension en utilisant une horloge de hachage ;

un amplificateur Gm de rétroaction configuré pour convertir la seconde tension en un courant de rétroaction ; et

un commutateur de démodulation configuré pour démoduler un signal de sortie de l'unité d'ajout de courant en utilisant l'horloge de hachage ;

un étage de sortie (19) configuré pour amplifier le signal démodulé par le commutateur de démodulation et pour émettre le signal en tant que tension de sortie ; et

un circuit de génération de signal de référence configuré pour générer la tension de référence,

dans lequel l'unité d'ajout de courant est configurée pour ajouter le premier courant, le deuxième courant et le courant de rétroaction.

3. Circuit de détection de signal de force électromotrice à effet Hall selon la revendication 2, dans lequel la première unité de commande de rétroaction inclut une multitude d'unités de calcul de tension commune à effet Hall configurées pour calculer une tension commune moyenne des premier et deuxième signaux de force électromotrice à effet Hall et une multitude d'unités de régulation de tension commune à effet Hall ; et

la multitude d'unités de régulation de tension commune à effet Hall inclut un comparateur configuré pour émettre, selon un résultat de comparaison entre la tension commune moyenne calculée par la multitude d'unités de calcul de tension commune à effet Hall et la tension de référence, une multitude de signaux de régulation de tension commune à effet Hall pour mettre en correspondance la tension commune moyenne avec la tension de référence et une source de courant variable configurée pour générer, sur la base de la multitude de signaux de régulation de tension commune à effet Hall émis à partir du comparateur, un courant de correction d'excitation d'élément à effet Hall et pour délivrer en sortie le courant de correction d'excitation d'élément à effet Hall à la première unité d'alimentation en courant d'attaque (13) et à la deuxième unité d'alimentation en courant d'attaque (14).

4. Circuit de détection de signal de force électromotrice à effet Hall selon la revendication 2, comprenant en outre :

un troisième élément à effet Hall incluant une pluralité de bornes ;

un quatrième élément à effet Hall incluant une pluralité de bornes ;

une troisième unité d'alimentation en courant d'attaque configurée pour fournir un courant d'attaque à la pluralité de bornes du troisième élément à effet Hall dans le premier ordre afin d'amener le troisième élément à effet Hall à générer un troisième signal de force électromotrice à effet Hall ;

une quatrième unité d'alimentation en courant d'attaque configurée pour fournir un courant d'attaque à la pluralité de bornes du quatrième élément à effet Hall dans le second ordre afin d'amener le quatrième élément à effet Hall à générer un quatrième signal de force électromotrice à effet Hall ;

un troisième amplificateur Gm configuré pour convertir le troisième signal de force électromotrice à effet Hall en un troisième courant ; et

un quatrième amplificateur Gm configuré pour convertir le quatrième signal de force électromotrice à effet Hall en un quatrième courant,

dans lequel la première unité de commande de rétroaction est configurée pour effectuer une commande de rétroaction de telle sorte que des tensions communes des premier, deuxième, troisième et quatrième signaux de force électromotrice à effet Hall correspondent avec la tension de référence ; et
dans lequel l'unité d'ajout de courant est configurée pour ajouter les premier, deuxième, troisième et quatrième courants au courant de rétroaction.

5. Circuit de détection de signal de force électromotrice à effet Hall selon la revendication 4, dans lequel la première unité de commande de rétroaction inclut une multitude d'unités de calcul de tension commune à effet Hall (31a) configurées pour calculer une tension commune moyenne des premier, deuxième, troisième et quatrième signaux de force électromotrice à effet Hall et une multitude d'unités de régulation de tension commune à effet Hall ; et la multitude d'unités de régulation de tension commune à effet Hall inclut un comparateur configuré pour émettre, selon un résultat de comparaison entre la tension commune moyenne calculée par la multitude d'unités de calcul de tension commune à effet Hall et la tension de référence, une multitude de signaux de régulation de tension commune à effet Hall pour mettre en correspondance la tension commune moyenne avec la tension de référence et une source de courant variable configurée pour générer, sur la base de la multitude de signaux de régulation de tension commune à effet Hall émis à partir du comparateur, un courant de correction d'excitation d'élément à effet Hall et pour délivrer en sortie le courant de correction d'excitation d'élément à effet Hall aux première, deuxième, troisième et quatrième unités d'alimentation en courant d'attaque.

6. Circuit de détection de signal de force électromotrice à effet Hall selon la revendication 4, dans lequel la première unité de commande de rétroaction est configurée pour effectuer la commande de rétroaction sur la base de deux signaux parmi les premier, deuxième, troisième et quatrième signaux de force électromotrice à effet Hall, dans lesquels des polarités de composants de pointe qui sont superposés sur les deux signaux, sont mutuellement différentes.

7. Circuit de détection de signal de force électromotrice à effet Hall selon l'une quelconque des revendications 2 à 6, comprenant en outre :
une deuxième unité de commande de rétroaction configurée pour recevoir la tension de sortie et la tension de référence et pour effectuer une commande de rétroaction de telle sorte qu'une tension commune de l'étage de sortie (19) corresponde à la tension de référence.

8. Circuit de détection de signal de force électromotrice à effet Hall selon l'une quelconque des revendications 2 à 7, comprenant en outre :
un étage d'amplification (61) configuré pour convertir le signal de sortie de l'unité d'ajout de courant en une tension, pour amplifier la tension et pour délivrer en sortie au commutateur de démodulation.

9. Circuit de détection de signal de force électromotrice à effet Hall selon la revendication 8, dans lequel l'étage d'amplification inclut une borne d'ajustement de tension commune et le circuit de détection de signal de force électromotrice à effet Hall comprend en outre une troisième unité de commande de rétroaction configurée pour recevoir la tension de sortie et la tension de référence et pour renvoyer un signal de commande à la borne d'ajustement de tension commune de telle sorte que la tension commune de l'étage de sortie (19) corresponde à la tension de référence.

10. Circuit de détection de signal de force électromotrice à effet Hall selon la revendication 1 :

dans lequel la première unité de commande de rétroaction est configurée pour effectuer la commande de rétroaction de telle sorte que des tensions communes des premier et deuxième signaux de force électromotrice à effet Hall correspondent à une première tension de référence en tant que tension de référence,
dans lequel le circuit de détection de signal de force électromotrice à effet Hall comprend en outre :

une unité de rétroaction configurée pour réaliser une rétroaction sur une première tension obtenue en divisant une différence entre une tension de sortie et une seconde tension de référence ;
un commutateur de modulation configuré pour moduler la première tension en utilisant une horloge de hachage pour générer une seconde tension ;
un amplificateur Gm de rétroaction configuré pour convertir la seconde tension en un courant de rétroaction ;
un commutateur de démodulation configuré pour démoduler un signal de sortie de l'unité d'ajout de courant en utilisant l'horloge de hachage ;
un étage de sortie (19) configuré pour amplifier le signal démodulé par le commutateur de démodulation et pour émettre le signal en tant que tension de sortie ; et
un circuit de génération de signal de référence configuré pour générer la première tension de référence et la seconde tension de référence,
dans lequel l'unité d'ajout de courant est configurée pour ajouter le premier courant, le deuxième courant, et le courant de rétroaction, et
dans lequel la première tension de référence et la seconde tension de référence sont générées sur la base d'une seule source de tension incluant des caractéristiques de température de sortie prédéterminées.

11. Circuit de détection de signal de force électromotrice à effet Hall selon la revendication 10, dans lequel les caractéristiques de température de sortie de la source de tension sont constantes.

12. Circuit de détection de signal de force électromotrice à effet Hall selon la revendication 1, dans lequel
la première unité de commande de rétroaction est configurée pour calculer une tension commune moyenne des premier et deuxième signaux de force électromotrice à effet Hall et pour effectuer une commande de rétroaction sur la base de la tension commune moyenne calculée.

13. Capteur de courant incluant le circuit de détection de signal de force électromotrice à effet Hall selon l'une quelconque des revendications 1 à 12.

FIG. 1

EP 3 176 593 B1

## 0 DEGREES
### WHEN CHOPPER CLOCK PHASE = $\phi1$
⊙ MAGNETIC FIELD

FIG. 2A

+Vsig(B)

11

TERMINAL 2

TERMINAL 3  TERMINAL 1

DRIVE CURRENT  Vhall1($\phi1$)

TERMINAL 4

−Vsig(B)

Vbias−

Vbias+

Ibias1  15

GND  GND

## 90 DEGREES
### WHEN CHOPPER CLOCK PHASE = $\phi2$
⊙ MAGNETIC FIELD

DRIVE CURRENT

FIG. 2B  11

TERMINAL 2

TERMINAL 3  TERMINAL 1  −Vsig(B)

TERMINAL 4  Vhall1($\phi2$)

+Vsig(B)

Vbias+

Vbias−

Ibias1  15

GND  GND

## 270 DEGREES
### WHEN CHOPPER CLOCK PHASE = $\phi1$
⊙ MAGNETIC FIELD

FIG. 2C  12

TERMINAL 2

TERMINAL 3  TERMINAL 1  +Vsig(B)

TERMINAL 4  Vhall2($\phi1$)

−Vsig(B)

Vbias−  Vbias+

Ibias2  16  DRIVE CURRENT

GND  GND

## 180 DEGREES
### WHEN CHOPPER CLOCK PHASE = $\phi2$
⊙ MAGNETIC FIELD

−Vsig(B)

FIG. 2D  12

TERMINAL 2

DRIVE CURRENT  TERMINAL 1

TERMINAL 3  Vhall2($\phi2$)

TERMINAL 4

+Vsig(B)

Vbias+

Vbias−

Ibias2  16

GND  GND

FIG. 3A  CHOPPER CLOCK PHASE

FIG. 3B  POSITIVE PHASE COMPONENT OF SIGNAL WAVEFORM OF Vhall1 (POSITIVE PHASE COMPONENT OF DIFFERENTIAL SIGNAL A1)

FIG. 3C  NEGATIVE PHASE COMPONENT OF SIGNAL WAVEFORM OF Vhall1 (NEGATIVE PHASE COMPONENT OF DIFFERENTIAL SIGNAL A1)

FIG. 3D  SIGNAL WAVEFORM OF Vhall1 (DIFFERENTIAL SIGNAL A1)

EP 3 176 593 B1

EP 3 176 593 B1

**FIG. 4A** CHOPPER CLOCK PHASE

| $\phi 1$ | $\phi 2$ | $\phi 1$ | $\phi 2$ |
|---|---|---|---|

**FIG. 4B** POSITIVE PHASE COMPONENT OF SIGNAL WAVEFORM OF Vhall2 (POSITIVE PHASE COMPONENT OF DIFFERENTIAL SIGNAL A2)

Vbias+
+Vsig(B)
−Vsig(B)
Vbias−

**FIG. 4C** NEGATIVE PHASE COMPONENT OF SIGNAL WAVEFORM OF Vhall2 (NEGATIVE PHASE COMPONENT OF DIFFERENTIAL SIGNAL A2)

Vbias+
+Vsig(B)
−Vsig(B)
Vbias−

**FIG. 4D** SIGNAL WAVEFORM OF Vhall2 (DIFFERENTIAL SIGNAL A2)

+2Vsig(B)
0
−2Vsig(B)

TIME

FIG. 5A  CHOPPER CLOCK PHASE

FIG. 5B  SIGNAL WAVEFORM OF Vhall1 (DIFFERENTIAL SIGNAL A1)

FIG. 5C  SIGNAL WAVEFORM OF Vhall2 (DIFFERENTIAL SIGNAL A2)

FIG. 5D  SIGNAL WAVEFORM OF DIFFERENTIAL SIGNAL B

FIG. 5E  SIGNAL WAVEFORM OF DIFFERENTIAL SIGNAL E

EP 3 176 593 B1

FIG. 6

FIG. 7

FIG. 8

FIG. 9

EP 3 176 593 B1

EP 3 176 593 B1

FIG. 10

FIG. 11

EP 3 176 593 B1

FIG. 12

FIG. 13

EP 3 176 593 B1

# FIG. 14

71

REFERENCE SIGNAL GENERATION SOURCE

72

VOLTAGE SOURCE

Vref

73

VOLTAGE DIVIDER CIRCUIT

→ Vcom1
→ Vcom2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013178229 A
- US 2013193962 A1
- US 5844427 A
- US 2014103921 A1
- JP 2006126012 A
- US 2012286776 A1
- US 2014210458 A1
- JP 2014167422 A